# EUROPEAN PATENT SPECIFICATION

(11) **EP 3 730 307 B1**
(45) Date of publication and mention of the grant of the patent: **23.10.2024**
(21) Application number: 19746880.4
(22) Date of filing: 30.01.2019
(51) Int. Cl.: B41C 1/10, G03F 7/00, G03F 7/004, G03F 7/031, G03F 7/038

(54) **PLANOGRAPHIC PRINTING PLATE PRECURSOR AND PRODUCTION METHOD FOR PLANOGRAPHIC PRINTING PLATE**
FLACHDRUCKPLATTENVORLÄUFER UND HERSTELLUNGSVERFAHREN FÜR EINE FLACHDRUCKPLATTE
PLAQUE ORIGINALE DE PLAQUE D'IMPRESSION LITHOGRAPHIQUE ET PROCÉDÉ DE FABRICATION DE PLAQUE D'IMPRESSION LITHOGRAPHIQUE

(30) Priority: 31.01.2018 JP 2018014900
(43) Date of publication of application: 28.10.2020
(73) Proprietor: FUJIFILM Corporation, Tokyo 106-8620 (JP)
(72) Inventor: ENOMOTO, Kazuaki, Shizuoka 421-0396 (JP); ARAKI, Kenjiro, Shizuoka 421-0396 (JP)
(74) Representative: Hoffmann Eitle
(86) International application number: PCT/JP2019/003268
(87) International publication number: WO 2019/151361

(56) References cited:
- EP-A1- 2 363 748
- EP-A1- 2 660 068
- WO-A1-2017/186556
- JP-A- 2014 069 452
- JP-A- 2016 179 592
- JP-A- 2017 019 206
- US-A1- 2009 246 696
- US-A1- 2015 000 544

## Description

### BACKGROUND OF THE INVENTION

### 1. Field of the Invention

The present disclosure relates to a planographic printing plate precursor and a method of producing a planographic printing plate.

### 2. Description of the Related Art

A planographic printing plate typically consists of a lipophilic image area which receives ink and a hydrophilic non-image area which receives dampening water, in the printing process. Planographic printing is a method of printing an image by setting a lipophilic image area of a planographic printing plate as an ink receiving unit and a hydrophilic non-image area of the planographic printing plate as a dampening water receiving unit (ink non-receiving unit) using the property in which water and oily ink repel each other, causing a difference in adhesiveness of ink to the surface of the planographic printing plate, allowing the ink to be impressed only on an image area, and transferring the ink to a printing medium such as paper.

In the related art, in order to produce the planographic printing plate, a planographic printing plate precursor (PS plate) which includes a lipophilic photosensitive resin layer (image recording layer) provided on a hydrophilic support has been widely used. Normally, the planographic printing plate is obtained by performing plate-making with a method of remaining a portion, which is an image area of the image recording layer, after subjecting the planographic printing plate precursor to be exposed through an original image such as a lith film, dissolving and removing other unnecessary image recording layers with an alkaline developer or an organic solvent, and forming a non-image area by exposing a hydrophilic surface of the support.

In addition, with a growing interest in the global environment, environmental issues related to a waste liquid associated with wet treatments such as a development treatment have been highlighted.

With respect to the environmental issues, it is desired to simplify development or plate-making, or not to perform the treatment. As one of a simple producing method, a method referred to as an "on-press development" has been performed. That is, the on-press development is a method of image-exposing a planographic printing plate precursor, mounting the planographic printing plate precursor in a printing press without performing development in the related art, and then removing unnecessary portions of the image recording layer at an initial stage of a typical printing step.

As the planographic printing plate precursor in the related art or the printing method using the planographic printing plate precursor, those described in JP2012-148555A or JP2017-154318A can be exemplified.

JP2012-148555A describes a planographic printing plate precursor comprising an image recording layer on a support, which contains a binder, a radical polymerizable compound, and a radical polymerization initiator, in which the binder has, as a nucleus of a polyfunctional thiol having 6 to 10 functional groups, a polymer chain bonded to the nucleus by a sulfide bond, and the polymer chain has a polymerizable group.

JP2017-154318A describes an on-press development type planographic printing plate dummy plate comprising at least one configuration layer on an aluminum support, which is mounted in the same plate cylinder of a printing press, in which at least one layer of the configuration layer contains a low-molecular weight hydrophilic compound, and discloses a printing method comprising a step of subjecting an on-press development type planographic printing plate precursor that has an image recording layer on the aluminum support, which contains a polymerization initiator including an organic boron-containing anion, to an on-press development.
US 2009 246696 A1 describes planographic printing plate precursor having at least: a support; and an image recording layer that is provided on or above the support, the image recording layer containing at least: an infrared ray absorbing agent (A); a polymerization initiator (B); a polymerizable monomer (C); and a polymer compound (D) having, in a side chain thereof, at least one specific polymerizable functional group having a hydroxyl group; and following exposure of the planographic printing plate precursor, an unexposed portion of the image recording layer is removed with a gum solution. EP 2 660 068 A1 describes a lithographic printing plate precursor comprising on a support having a hydrophilic surface, an image-recording layer containing a polymerizable compound, a polymerization initiator, a fme particle of polymer having a polyethyleneoxy group in its side chain and a polymer compound, wherein the polymer compound has a starlike shape in which a main chain is branched to three or more branches and the branched main chains have at least any of a polyethyleneoxy group and a polypropyleneoxy group in their side chains.

JP 2014/069452 A describes a lithographic printing plate original plate having an image recording layer in which an unexposed part is removed by at least any one of moistening water and ink on a support, wherein the image recording layer contains (a) a compound in which a linear molecule penetrates through cyclic molecules having a polymerizable group, (b) a polyfunctional monomer, (c) a binder polymer having a mass-average molecular weight of 20,000 to 200,000, (d) a polymerization initiator and (e) a sensitizing dye.

JP 2017/019206 A1 describes a stacked body of lithographic printing plate precursors that includes a plurality of lithographic printing plate precursors. The lithographic printing plate precursor has a support body and an image recording layer and such a structure that: on a plate surface on the image recording layer side at ends of two side faces opposing to each other of the lithographic printing plate precursor, a hydrophilic region prepared by treating with a hydrophilizing component is formed.

JP 2016/179592 A1 describes an original plate of planographic printing plate includes one or more layers on a supporting body. The original plate is characterized in that the droop quantities X at edges of two or four opposing sides of the supporting body are 20 µm to 150 µm, the one or more layers comprise an image recording layer, at least one of the one or more layers contains a chelate agent, and at least one of the one or more layers contains an acid coloring agent.

EP 2 363 748 A1 describes a lithographic printing plate precursor of on-press development type. The lithographic printing plate precursor includes a support and an image-recording layer, an unexposed area of which is capable of being removed with dampening water and/or printing ink and contains (a) an infrared absorbing agent, (b) a radical polymerization initiator, (c) a polymer particle, and (d) a radical polymerizable urethane oligomer, wherein (d) the radical polymerizable urethane oligomer has a polymerizable group and at least one hydrophilic group selected from a sulfo group, a group having a polyoxyalkylene chain, a hydroxy group, an amido group, an ammonium group and a group having a betaine structure and a weight average molecular weight (Mw) from 1,500 to 10,000 and is present outside of (c) the polymer particle.

### SUMMARY OF THE INVENTION

In the planographic printing plate, a planographic printing plate excellent in the number of printable sheets in the plate (hereinafter, also referred to as "printing durability") has been required.

The present inventors have found that, according to a planographic printing plate precursor according to an aspect of the present disclosure, it is possible to further improve printing durability as compared with the planographic printing plate precursor described in JP2012-148555A or JP2017-154318A.

An object to be achieved by an embodiment of the present disclosure is to provide a planographic printing plate precursor having excellent printing durability and a method of producing a planographic printing plate obtained by using the planographic printing plate precursor.

The method for achieving the above-described objects is defined in the claims and described below.

According to the present disclosure, it is possible to provide a planographic printing plate precursor having excellent printing durability and a method of producing a planographic printing plate obtained by using the planographic printing plate precursor.

### DESCRIPTION OF THE PREFERRED EMBODIMENTS

Hereinafter, the contents of the present disclosure will be described in detail. The description of constituent elements below is made based on representative embodiments of the present disclosure in some cases, but the present disclosure is not limited to such embodiments.

In the present specification, the numerical ranges shown using "to" indicate ranges including the numerical values described before and after "to" as a lower limit value and an upper limit value.

In addition, in a case where substitution or unsubstitution is not noted in regard to the notation of a "group" (atomic group) in the present specification, the "group" includes not only a group not having a substituent but also a group having a substituent. For example, the concept of an "alkyl group" includes not only an alkyl group not having a substituent (unsubstituted alkyl group) but also an alkyl group having a substituent (substituted alkyl group).

In the present specification, the concept of "(meth)acryl" includes both of acryl and methacryl, and the concept of "(meth)acryloyl" includes both of acryloyl and methacryloyl.

In addition, the term "step" in the present specification indicates not only an independent step but also a step which cannot be clearly distinguished from other steps as long as the intended purpose of the step is achieved. In addition, in the present disclosure, "% by mass" has the same definition as that for "% by weight", and "part by mass" has the same definition as that for "part by weight".

In the present disclosure, in a case where the amount of each component in a composition is referred to, and in a case where a plurality of substances corresponding to each component in the composition are present, it means the total amount of a plurality of substances present in the composition, unless otherwise specified.

In addition, in the present disclosure, a combination of two or more preferred aspects is a more preferred aspect.

In addition, the weight-average molecular weight (Mw) and the number-average molecular weight (Mn) in the present disclosure are molecular weights in terms of polystyrene used as a standard substance, which are detected by using a solvent tetrahydrofuran (THF), a differential refractometer, and a gel permeation chromatography (GPC) analyzer using TSKgel GMHxL, TSKgel G4000HxL, and TSKgel G2000HxL (all trade names manufactured by Tosoh Corporation) as columns, unless otherwise specified.

In the present disclosure, the term "planographic printing plate precursor" includes not only a planographic printing plate precursor but also a key plate precursor. In addition, the term "planographic printing plate" includes not only a planographic printing plate produced by performing operations such as exposure and development, on a planographic printing plate precursor as necessary but also a key plate. In a case of the key plate precursor, operations of exposure and development are not necessarily required. In addition, a key plate is a planographic printing plate precursor for attachment to a plate cylinder which is not used, for example, in a case where printing is performed on a part of a paper surface with one or two colors in color newspaper printing.

In addition, in the present disclosure, "*" in chemical structural formulae represents a bonding position with another structure.

Hereinafter, the present disclosure will be described in detail.

### (Planographic printing plate precursor)

The planographic printing plate precursor according to the embodiment of the present disclosure includes a support and an image recording layer formed on the support, in which the image recording layer contains a polymer A which includes a constitutional unit A1 having an ethylenically unsaturated group, a weight-average molecular weight of the polymer A is in a range of 2,500 to 35,000, and a content of the constitutional unit A1 in the polymer A is 15 mol% or more. Further, the sulfur content of the polymer A is in a range of 0.5% by mass to 10% by mass with respect to a total mass of the polymer A, wherein the sulfur content derives from a constitutional unit derived from a monofunctional thiol compound or a bifunctional thiol compound, or a constitutional unit derived from a polyfunctional thiol compound having 3 to 10 functional groups.

In addition, the planographic printing plate precursor according to the embodiment of the present disclosure can be suitably used as a planographic printing plate precursor for on-press development.

As a result of intensive research conducted by the present inventor, it has been found that a planographic printing plate precursor which has excellent printing durability can be provided by employing the above-described configuration.

The detailed mechanism for obtaining the above-described effect is not clear, but assumed as follows.

In the planographic printing plate precursor described in JP2012-148555A or JP2017-154318A, in order to further improve printing durability, it is conceivable to increase the amount of cross-linking group of the polymer (binder polymer) included in the image recording layer. However, according to the study by the present inventors, printing durability is not significantly improved only by simply increasing the amount of cross-linking group.

As a result of intensive research conducted by the present inventors, it has been found that, by increasing the amount of cross-linking group in the polymer A used in the present disclosure and by reducing the weight-average molecular weight of the polymer A, printing durability is significantly improved.

This is assumed that, by reducing the molecular weight of the polymer A, the compatibility between the polymer A and other components such as a polymerizable compound added to the image recording layer is improved, and by increasing the amount of cross-linking group, the effect of densification of the crosslinked structure is more likely to appear.

In addition, it is considered that, by reducing the molecular weight of the polymer A, the content of sulfur element in the polymer A relatively increases and influence of interatomic interaction such as an interaction between S (sulfur atom)-O (oxygen atom) increases, which is also involved a mechanism improving printing durability.

In addition, in recent years, an ink (also referred to as an "ultraviolet curable ink") which is cured by irradiation of ultraviolet rays (UV) may be used as an ink in printing.

The ultraviolet curable ink has advantages such as high productivity due to being instantaneously dryable, easily reduced environmental pollution since the content of a solvent is small or the ink is solventless, expanded application range of printing target or the like since an image can be formed without drying by heat or formed by drying with heat in a short time.

Therefore, it is considered that a planographic printing plate precursor which can provide a planographic printing plate having excellent printing durability (hereinafter, also referred to as "UV printing durability") in a case of using the ultraviolet curable ink is extremely useful industrially.

In the present disclosure, printing durability in a case of using a typical oily ink which is not the ultraviolet curable ink is simply referred to as "printing durability" or "oil printing durability".

The present inventors have found that, in the planographic printing plate precursor according to the embodiment of the present disclosure, UV printing durability is easily improved. The detailed mechanism for obtaining the above-described effect is not clear, but the reason is assumed that, same as the above-described improvement of printing durability, the effect of densification of the crosslinked structure is more likely to appear and the influence of interatomic interaction such as the interaction between S-O increases.

Furthermore, in the planographic printing plate precursor, particularly in a case of performing on-press development, printing stains (hereinafter, also referred to as a "spot scumming") in small area (for example, a diameter of 20 µm to 2,000 µm), which are dot shape, ring shape, or the like, may occur on a printed material obtained using a planographic printing plate after development.

It is assumed that the spot scumming is caused by insufficient removal of an image recording layer with development (generation of local residual film) for the reason that, for example, in an aluminum support, local corrosion occurs and a polymer is formed in the corroded portion.

As a result of intensive research conducted by the present inventors, it has been found that, in the planographic printing plate precursor according to the embodiment of the present disclosure, the occurrence of the spot scumming after development is easily suppressed.

This is assumed that, since the molecular weight of the polymer A is small, the molecular weight of the above-described polymer to be formed is also relatively small, therefore removability of the residual film with development is improved.

In addition, as a result of intensive research conducted by the present inventors, it has been found that, in the planographic printing plate precursor according to the embodiment of the present disclosure, on-press developability is easily improved.

This is assumed that, since the molecular weight of the polymer A is small, a non-image area is easily removed by on-press development.

Hereinafter, the details of each constituent element in the planographic printing plate precursor according to the embodiment of the present disclosure will be described.

### <Support>

The planographic printing plate precursor according to the embodiment of the present disclosure has a support.

As the support, a support (also referred to as a "hydrophilic support") having a hydrophilic surface is preferable. The hydrophilic surface preferably has a contact angle with water of lower than 10° and more preferably has a contact angle with water of lower than 5°.

The support in the planographic printing plate precursor according to the embodiment of the present disclosure can be appropriately selected and used from known supports for a planographic printing plate precursor. As the support, an aluminum plate which is subjected to a roughening treatment and anodizing treatment by a known method is preferable.

The aluminum plate may be further subjected to a treatment appropriately selected from an expansion treatment or a sealing treatment of micropores of an anodized film described in JP2001-253181A and JP2001-322365A, a surface hydrophilization treatment using alkali metal silicate described in US2714066A, US3181461A, US3280734A, and US3902734A, or a surface hydrophilization treatment using polyvinyl phosphonic acid described in US3276868A, US4153461A, and US4689272A, as necessary.

The center line average roughness of the support is preferably in a range of 0.10 µm to 1.2 µm.

The support may have, as necessary, a back coat layer including an organic polymer compound described in JP1993-045885A (JP-H05-045885A), an alkoxy compound of silicon described in JP1994-035174A (JP-H06-035174A), or the like on a surface opposite to the image recording layer.

### <Image recording layer>

The planographic printing plate precursor according to the embodiment of the present disclosure has an image recording layer formed on the support.

The image recording layer used in the present disclosure is preferably a negative type image recording layer and more preferably a water-soluble or water-dispersible negative type image recording layer.

From the viewpoint of printing durability and photosensitivity, it is preferable that the image recording layer used in the present disclosure further includes an electron-accepting polymerization initiator and a polymerizable compound.

From the viewpoint of exposure sensitivity, it is preferable that the image recording layer used in the present disclosure further includes an infrared absorbent.

In order to confirm an exposed area before development, it is preferable that the image recording layer used in the present disclosure further includes an acid color developing agent.

From the viewpoint of on-press developability, it is preferable that, in the planographic printing plate precursor according to the embodiment of the present disclosure, an unexposed area of the image recording layer can be removed by at least any one of dampening water and printing ink.

Hereinafter, the details of each component included in the image recording layer will be described.

### [Polymer A including constitutional unit A1 having ethylenically unsaturated group]

The image recording layer used in the present disclosure contains a polymer A (hereinafter, also simply referred to as a "polymer A") including a constitutional unit A1 having an ethylenically unsaturated group. The sulfur content of the polymer A is in a range of 0.5% by mass to 10% by mass with respect to a total mass of the polymer A, wherein the sulfur content derives from a constitutional unit derived from a monofunctional thiol compound or a bifunctional thiol compound, or a constitutional unit derived from a polyfunctional thiol compound having 3 to 10 functional groups.

The weight-average molecular weight (Mw) of the polymer A is in a range of 2,500 to 35,000, and from the viewpoint of improving printing durability, on-press developability, and UV printing durability and suppressing the occurrence of the spot scumming, is preferably in a range of 2,500 to 20,000 and more preferably in a range of 5,000 to 18,000.

In addition, from the viewpoint of improving printing durability and UV printing durability, the content of the constitutional unit A1 (hereinafter, also simply referred to as a "constitutional unit A1") having an ethylenically unsaturated group in the polymer A is 15 mol% or more, preferably 30 mol% or more, and more preferably 40 mol% or more.

The polymer A may singly contain one kind of the constitutional unit A1 or may contain two or more kinds of thereof.

From the viewpoint of improving on-press developability and suppressing the occurrence of the spot scumming, the content of the constitutional unit A1 in the polymer A is preferably 80 mol% or less and more preferably 60 mol% or less.

In the present disclosure, a molar content (mol%) of a constitutional unit in a polymer is a value obtained from the constitutional unit in terms of a monomer unit. Specifically, a molar content (mol%) of a specific constitutional unit in a polymer represents a content (%) of a specific monomer unit with respect to the total content of monomer units included in the polymer.

### -Constitutional unit A1-

The constitutional unit A1 is a constitutional unit having an ethylenically unsaturated group. The ethylenically unsaturated group is not particularly limited, and examples thereof include a vinyl group, an allyl group, a vinylphenyl group, a (meth)acrylamide group, and a (meth)acryloxy group. From the viewpoint of reactivity, among these, a (meth)acryloxy group is preferable.

The constitutional unit A1 can be introduced into the polymer A by a polymer reaction or copolymerization. Specifically, the constitutional unit A1 can be introduced into the polymer A by, for example, a method of reacting a compound (such as glycidyl methacrylate) having an epoxy group and an ethylenically unsaturated group with a polymer into which a constitutional unit having a carboxy group, such as methacrylic acid, is introduced, a method of reacting a compound (such as 2-isocyanatoethyl methacrylate) having an isocyanate group and an ethylenically unsaturated group with a polymer into which a constitutional unit having a group having an active hydrogen, such as a hydroxy group, is introduced, and the like.

In addition, the constitutional unit A1 may be introduced into the polymer A by a method of reacting a compound having a carboxy group and an ethylenically unsaturated group with a polymer into which a constitutional unit having an epoxy group, such as glycidyl (meth)acrylate, is introduced.

Furthermore, the constitutional unit A1 may be introduced into the polymer A by, for example, using a monomer including a partial structure represented by Formula a1 or Formula a2. Specifically, the constitutional unit A1 is introduced into the polymer A by, for example, polymerizing at least the above-described monomer, and then performing elimination reaction to the partial structure represented by Formula a1 or Formula a2 using a basic compound to form an ethylenically unsaturated group.

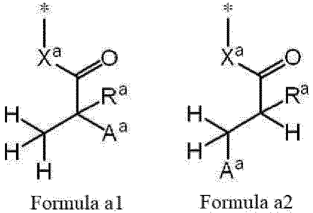

In Formula a1 and Formula a2, R^{a} represents a hydrogen atom or an alkyl group, A^{a} represents a halogen atom, X^{a} represents -O- or -NR^{N}-, and R^{N} represents a hydrogen atom or an alkyl group.
In Formula a1 and Formula a2, R^{a} is preferably a hydrogen atom or a methyl group.
In Formula a1 and Formula a2, A^{a} is preferably a chlorine atom, a bromine atom, or an iodine atom.
In Formula a1 and Formula a2, X^{a} is preferably -O-. In a case where X^{a} represents -NR^{N}-, R^{N} is preferably a hydrogen atom or an alkyl group having 1 to 4 carbon atoms and more preferably a hydrogen atom.

Examples of the constitutional unit A1 include a constitutional unit represented by Formula A-1.

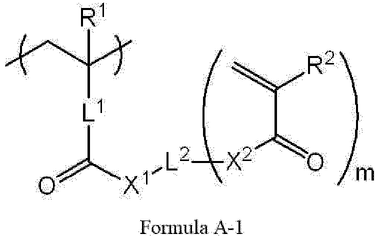

In Formula A-1, L¹ represents a single bond or a divalent linking group, L² represents an m+1-valent linking group, X¹ and X² each independently represent -O- or -NR^{N}-, R^{N} represents a hydrogen atom or an alkyl group, R¹ and R² each independently represent a hydrogen atom or a methyl group, and m represents an integer of 1 or greater.

In Formula A-1, L¹ is preferably a single bond. In a case where L¹ represents a divalent linking group, L¹ is preferably an alkylene group, an arylene group, or a divalent group represented by a bond thereof, and preferably an alkylene group having 2 to 10 carbon atoms or a phenylene group.

In Formula A-1, L² is preferably a group represented by any one of Formula A-2 to Formula A-6.

In Formula A-1, both of X¹ and X² are preferably -O-. In addition, in a case where at least one of X¹ or X² represents -NR^{N}-, R^{N} is preferably a hydrogen atom or an alkyl group having 1 to 4 carbon atoms and more preferably a hydrogen atom.

In Formula A-1, R¹ is preferably a methyl group.

In Formula A-1, at least one of m R² is preferably a methyl group.

In Formula A-1, m is preferably an integer of 1 to 4, more preferably 1 or 2, and still more preferably 1.

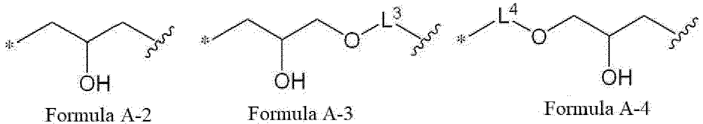

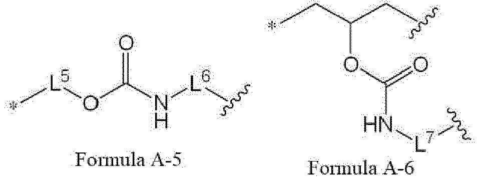

In Formula A-2 to Formula A-6, L³ to L⁷ represent a divalent linking group, L⁵ and L⁶ may be different from each other, * represents a bonding site with X¹ in Formula A-1, and a wavy line represents a bonding site with X² in Formula A-1.

In Formula A-3, L³ is preferably an alkylene group, an arylene group, or a group represented by a bond thereof, and more preferably an alkylene group having 1 to 10 carbon atoms, a phenylene group, or a group represented by a bond thereof.

In Formula A-4, L⁴ is preferably an alkylene group, an arylene group, or a group represented by a bond thereof, and more preferably an alkylene group having 1 to 10 carbon atoms, a phenylene group, or a group represented by a bond thereof.

In Formula A-5, L⁵ is preferably an alkylene group, an arylene group, or a group represented by a bond thereof, and more preferably an alkylene group having 1 to 10 carbon atoms, a phenylene group, or a group represented by a bond thereof.

In Formula A-5, L⁶ is preferably an alkylene group, an arylene group, or a group represented by a bond thereof, and more preferably an alkylene group having 1 to 10 carbon atoms, a phenylene group, or a group represented by a bond thereof.

In Formula A-6, L⁷ is preferably an alkylene group, an arylene group, or a group represented by a bond thereof, and more preferably an alkylene group having 1 to 10 carbon atoms, a phenylene group, or a group represented by a bond thereof.

Specific examples of the constitutional unit A1 include the constitutional unit A1 including in polymers P-1 to P-13 which are specific examples of the polymer A described later, but the constitutional unit A1 is not limited thereto.

### -Constitutional unit B1-

From the viewpoint of developability, it is preferable that the polymer A has a constitutional unit B1 (also simply referred to as a "constitutional unit B1") having a hydrophilic group.

A constitutional unit having a hydrophilic group and an ethylenically unsaturated group does not correspond to the constitutional unit B1 but corresponds to the constitutional unit A1.

Examples of the hydrophilic group in the constitutional unit B 1 include -SO₃M¹, -OH, -CONR¹R², -NR²COR¹ (M¹ represents a hydrogen atom, a metal ion, an ammonium ion, or a phosphonium ion, R¹ and R² each independently represent a hydrogen atom, an alkyl group, an alkenyl group, or an aryl group, and R¹ and R² may be bonded to each other to form a ring), -NR³R⁴, -N⁺R³R⁴R⁵X⁻ (R³ to R⁵ each independently represent an alkyl group having 1 to 8 carbon atoms and X⁻ represents a counter anion), and a group represented by Formula PO.

In addition, the constitutional unit B1 may be a constitutional unit derived from an N-vinyl lactam compound such as N-vinyl pyrrolidone and N-vinyl caprolactam, and residues in a case where these N-vinyl lactam compounds are used in a polymerization reaction also correspond to the hydrophilic group.

Among these hydrophilic groups, -CONR¹R² or a group represented by Formula PO is preferable and a group represented by Formula PO is more preferable.

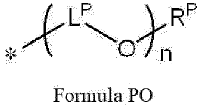

In Formula PO, each of L^{P} independently represents an alkylene group, R^{P} represents a hydrogen atom or an alkyl group, and n represents an integer of 1 to 100.

In Formula PO, each of L^{P} is independently preferably an ethylene group, a 1-methyl ethylene group, or a 2-methyl ethylene group, and more preferably an ethylene group.

In Formula PO, R^{P} is preferably a hydrogen atom or an alkyl group having 1 to 18 carbon atoms, more preferably a hydrogen atom or an alkyl group having 1 to 10 carbon atoms, still more preferably a hydrogen atom or an alkyl group having 1 to 4 carbon atoms, and particularly preferably a hydrogen atom or a methyl group.

In Formula PO, n is preferably an integer of 1 to 10 and more preferably an integer of 1 to 4.

In addition, from the viewpoint of improving printing durability and UV printing durability, it is preferable that the polymer A includes a constitutional unit including an ether bond as the constitutional unit B1. In a case where the polymer A includes a sulfur atom, it is considered that, by S-O interaction between an oxygen atom in the ether bond and the sulfur atom, printing durability and UV printing durability are easily improved.

Examples of the constitutional unit including an ether bond include a constitutional unit including the group represented by Formula PO.

The constitutional unit B1 is preferably a constitutional unit represented by Formula B-1.

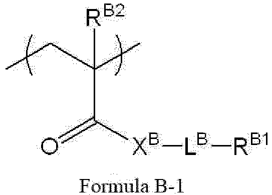

In Formula B-1, X^{B} represents -O- or -NR^{N}-, R^{N} represents a hydrogen atom or an alkyl group, L^{B} represents a single bond or a divalent linking group, R^{B1} represents a hydrophilic group, and R^{B2} represents a hydrogen atom or an alkyl group.

In Formula B-1, X^{B} is preferably -O-. In a case where X^{B} is -NR^{N}-, R^{N} is preferably a hydrogen atom or an alkyl group having 1 to 4 carbon atoms and more preferably a hydrogen atom.

In Formula B-1, L^{B} is preferably a single bond. In a case where L^{B} is a divalent linking group, L^{B} is preferably an alkylene group, an arylene group, or a group represented by a bond thereof, and preferably an alkylene group having 1 to 4 carbon atoms, a phenylene group, or a group represented by a bond thereof.

In Formula B-1, R^{B1} is preferably the above-described hydrophilic group in the constitutional unit B1, more preferably -CONR¹R² or a group represented by Formula PO, and still more preferably a group represented by Formula PO.

In Formula B-1, R^{B2} is preferably a hydrogen atom or an alkyl group having 1 to 4 carbon atoms, and more preferably a hydrogen atom or a methyl group.

The polymer A may singly contain one kind of the constitutional unit B1 or may contain two or more kinds thereof.

From the viewpoint of achieving both on-press developability and ink impressing property, the content of the constitutional unit B1 in the polymer A is preferably in a range of 0 mol% to 80 mol%, and more preferably in a range of 5 mol% to 60 mol%.

Specific examples of the constitutional unit B1 include the constitutional unit B1 include in polymers P-1 to P-11, and P-13 which are specific examples of the polymer A described later, but the constitutional unit B1 is not limited thereto.

### -Constitutional unit C1-

From the viewpoint of inking property, it is preferable that the polymer A contains a constitutional unit C1 including a hydrophobic group.

Examples of the hydrophobic group in the constitutional unit C1 include an alkyl group, an aryl group, and an aralkyl group.

As the alkyl group, an alkyl group having 1 to 10 carbon atoms is preferable, and examples thereof include a methyl group, an ethyl group, a propyl group, a cyclohexyl group, a 2-ethylhexyl group, and a dicyclopentanyl group.

As the aryl group, a phenyl group or a naphthyl group is preferable, and a phenyl group is more preferable.

As the aralkyl group, an aralkyl group in which an alkyl group has 1 to 10 carbon atoms and aryl group has 6 to 20 carbon atoms is preferable, an aralkyl group in which an alkyl group has 1 to 10 carbon atoms and an aryl group is a phenyl group is more preferable, and a benzyl group is still more preferable.

The constitutional unit C1 is preferably a constitutional unit represented by Formula C-1 or Formula C-2.

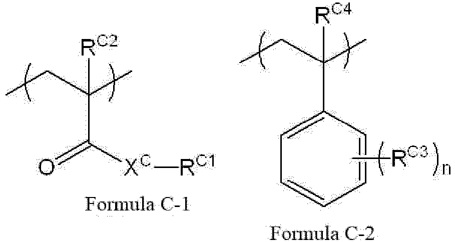

In Formula C-1, X^{C} represents -O- or -NR^{N}-, R^{N} represents a hydrogen atom or an alkyl group, R^{C1} represents a hydrophobic group, and R^{C2} represents a hydrogen atom or an alkyl group.

In Formula C-1, X^{C} is preferably -O-. In a case where X^{C} is -NR^{N}-, R^{N} is preferably a hydrogen atom or an alkyl group having 1 to 4 carbon atoms and more preferably a hydrogen atom.

In Formula C-1, R^{C1} is preferably the above-described hydrophobic group in the constitutional unit C1, preferably an alkyl group or an aralkyl group, and more preferably an alkyl group having 1 to 10 carbon atoms or an aralkyl group in which an alkyl group has 1 to 10 carbon atoms and an aryl group is a phenyl group.

In Formula C-1, R^{C2} is preferably a hydrogen atom or an alkyl group having 1 to 4 carbon atoms, and more preferably a hydrogen atom or a methyl group.

In Formula C-2, R^{C3} represents a monovalent substituent, R^{C4} represents a hydrogen atom or an alkyl group, and n represents an integer of 0 to 5.

In Formula C-2, R^{C3} is preferably an alkyl group, an aryl group, or an aralkyl group, and more preferably an alkyl group having 1 to 10 carbon atoms, aryl group having 6 to 20 carbon atoms, or an aralkyl group having 7 to 21 carbon atoms.

In Formula C-2, R^{C4} is preferably a hydrogen atom or a methyl group.

In Formula C-2, n is preferably an integer of 0 to 3, more preferably an integer of 0 to 2, still more preferably 0 or 1, and particularly preferably 0.

The polymer A may singly contain one kind of the constitutional unit C1 or may contain two or more kinds thereof.

From the viewpoint of achieving both on-press developability and ink impressing property, the content of the constitutional unit C1 in the polymer A is preferably in a range of 1 mol% to 80 mol%, and more preferably in a range of 3 mol% to 40 mol%.

Specific examples of the constitutional unit C1 include the constitutional unit C1 include in polymers P-1 to P-13 which are specific examples of the polymer A described later, but the constitutional unit C1 is not limited thereto.

### -Constitutional unit derived from polyfunctional thiol compound-

It is preferable that the polymer A is a star polymer including a constitutional unit derived from a polyfunctional thiol compound having 3 to 10 functional groups.

In order to form a star polymer, it is preferable that the polymer A has only one constitutional unit derived from a polyfunctional thiol compound having 3 to 10 functional groups.

In a case where the polymer A is a star macromolecule, the polymer A is n-star macromolecule, and n is preferably an integer of 3 to 10.

The polymer A may be a regular star macromolecule or a variegated star macromolecule.

The above-described star polymer can be produced by a known method of copolymerizing, in the presence of a polyfunctional thiol compound having 3 to 10 functional groups, a monomer constituting the constitutional unit A1, a monomer constituting the constitutional unit B1, and a monomer constituting the constitutional unit C1. Regarding the details of the above-described star polymer and the method of producing the polyfunctional thiol compound, reference can be made to the description of JP2012-148555A.

The above-described star polymer which is the polymer A in the present disclosure is different from the star polymer described in JP2012-148555A in the weight-average molecular weight and the content of the constitutional unit A1. In the method of producing the star polymer described in JP2012-148555A, the weight-average molecular weight and the content of the constitutional unit A1 can be controlled by, for example, adjusting the amount of the polyfunctional thiol compound used, the amount of a polymerization initiator used in a case of copolymerizing monomers, and the like.

The polyfunctional thiol compound having 3 to 10 functional groups used in the present disclosure is not particularly limited, but preferably a polyfunctional thiol compound having 3 to 8 functional groups and more preferably a polyfunctional thiol compound having 3 to 6 functional groups.

In addition, as the polyfunctional thiol compound having 3 to 10 functional groups used in the present disclosure, a compound represented by Formula S-1 is preferable.

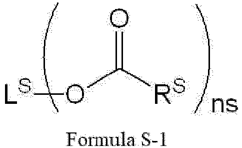

In Formula S-1, L^{S} represents an ns-valent hydrocarbon group which may include an ether bond, R^{S} represents a monovalent hydrocarbon group which has a thiol group as a substituent, and ns represents an integer of 3 to 10.

In Formula S-1, L^{S} is preferably an ns-valent aliphatic hydrocarbon group which may include an ether bond, and more preferably an ns-valent unsaturated aliphatic hydrocarbon group which may include an ether bond.

Specific examples of L^{S} include a structure in which all hydroxy groups included in a polyhydric alcohol compound, such as pentaerythritol, dipentaerythritol, sorbitol, mannitol, iditol, dulcitol, and inositol, are removed from the compound, but L^{S} is not limited thereto.

In Formula S-1, R^{S} is preferably a monovalent aliphatic hydrocarbon group which has a thiol group as a substituent, and more preferably a monovalent unsaturated aliphatic hydrocarbon group which has a thiol group as a substituent.

Specific examples of R^{S} include a mercaptomethyl group, a 2-mercaptoethyl group, and a 2-mercaptopropyl group, but R^{S} is not limited thereto.

In Formula S-1, ns represents an integer of 3 to 10, and is preferably an integer of 3 to 8 and more preferably an integer of 3 to 6.

In addition, as the polyfunctional thiol compound, compound A to compound F described in JP2012-148555A can also be suitably used.

### -Other constitutional unit-

The polymer A in the present disclosure may further include other constitutional units.

Examples of other constitutional units include a constitutional unit derived from a monofunctional thiol compound and a constitutional unit derived from a bifunctional thiol compound.

### -Content rate of sulfur element-

From the viewpoint of improving printing durability and UV printing durability, the content rate of a sulfur element is in a range of 0.5% by mass to 10% by mass and preferably in a range of 1% by mass to 5% by mass with respect to the total mass of the polymer A.

In a case where the content rate of the sulfur element is within the above-described range, it is considered that, by the influence of the above-described S-O interaction, printing durability and UV printing durability are easily improved.

The sulfur element is introduced into the polymer A as an element included in the above-described constitutional unit derived from a monofunctional thiol compound or a bifunctional thiol compound, or as an element included in a constitutional unit derived from the polyfunctional thiol compound having 3 to 10 functional groups described later.

Specific examples of the polymer A are shown in the following table, but the polymer A used in the present disclosure is not limited thereto.

**[Table 1]**

| Polymer A | *Thiol unit | Constitutional unitAl | mol % | Constitutional unit B1 | mol % | Constitutional unit C1 | mol % | * Sulfur content | *Mw |
|---|---|---|---|---|---|---|---|---|---|
| P-1 | SH1 | 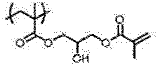 | 25 | 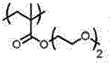 | 55 | 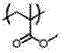 | 16 | 0.7 | 5000 |
| P-2 | SH2 | 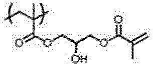 | 34 | 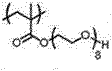 | 39 | 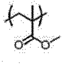 | 24 | 0.8 | 8000 |
| P-3 | SH3 | 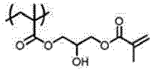 | 54 | 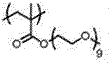 | 39 | 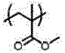 | 5 | 0.7 | 18000 |
| P-4 | SH4 | 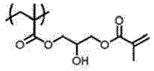 | 74 | 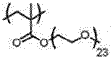 | 5 | 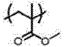 | 17 | 0.9 | 14000 |
| P-5 | SH5 | 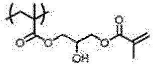 | 71 | 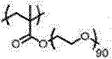 | 5 | 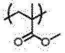 | 19 | 2.4 | 7000 |
| P-6 | SH5 | 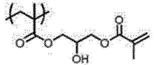 | 48 | 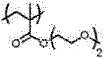 | 46 | 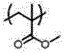 | 5 | 1.2 | 15000 |
| P-7 | SH5 | 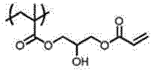 | 49 | 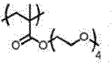 | 30 | 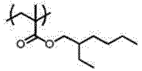 | 20 | 0.9 | 20000 |
| P-8 | SH5 | 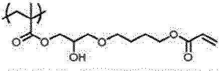 | 36 | 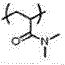 | 28 | 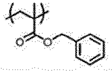 | 34 | 1.6 | 11000 |
| P-9 | SH5 | 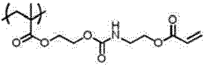 | 59 | 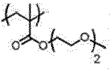 | 25 | 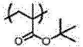 | 15 | 0.9 | 20000 |
| P-10 | SH5 | 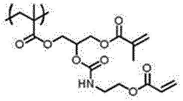 | 34 | 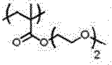 | 57 | 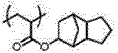 | 5 | 1.9 | 9000 |
| P-11 | SH5 | 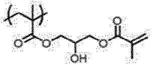 | as | 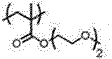 | 30 | 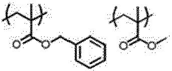 | 33 (5:5) | 1.5 | 12000 |
| P-12 | SH5 | 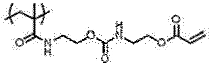 | 69 | Not contained | 0 | 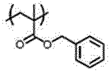 | 30 | 1.1 | 17000 |
| P-13 | SH5 | 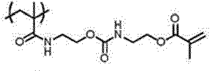 | 57 | 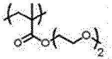 | 5 | 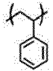 | 36 | 1.4 | 13000 |

| | | | | | | | | | |
|---|---|---|---|---|---|---|---|---|---|
| * "Thiol unit" represents the constitutional unit derived from polyfunctional thiol unit. * "Sulfur content" represents the content of sulfur atom (% by mass). * "Mw" represents the weight-average molecular weight. | | | | | | | | | |

In the above table, the description of mol% in the columns of constitutional unit A1 to constitutional unit C1 indicates the content (mol%) of each constitutional unit in the polymer A. For example, in P-1, the content of the constitutional unit A1 is 25 mol%, the content of the constitutional unit B1 is 55 mol%, the content of the constitutional unit C1 is 16 mol%, and the content of a constitutional unit SH1 derived from a polyfunctional thiol compound is 4 mol%.

In addition, in polymer P-11, the description of "33 (5:5)" in the column of mol% of constitutional unit C1 means that the two constitutional unit C1's are contained in a molar ratio of 5:5 and the total content thereof is 33 mol%.

The details of SH1 to SH5 in the table, which are constitutional units derived from a polyfunctional thiol compound, are shown below.

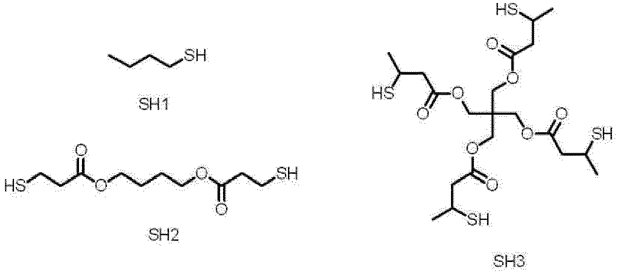

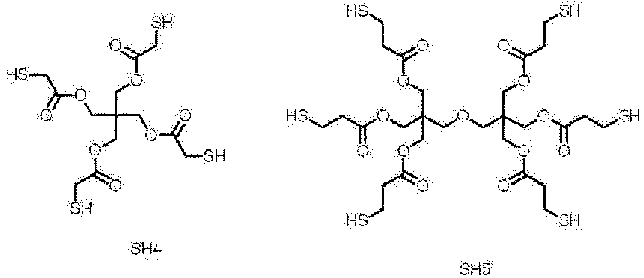

The polymer P-1 is a polymer A including a constitutional unit derived from a monofunctional thiol compound SH1, and is a compound in which a molecular chain formed by the constitutional unit A1 to constitutional unit C1, and SH1 are bonded by a sulfide bond derived from a thiol bond in SH1.

The polymer P-2 is a polymer A including a constitutional unit derived from a bifunctional thiol compound SH2, and is a compound in which a molecular chain formed by the constitutional unit A1 to constitutional unit C1, and SH2 are respectively bonded by a sulfide bond derived from a thiol bond in SH2. That is, it is considered that the polymer P-2 has two sulfide bonds.

The polymer P-3 is a polymer A including a constitutional unit derived from a tetrafunctional thiol compound SH3, and is a compound in which a molecular chain formed by the constitutional unit A1 to constitutional unit C1, and SH3 are respectively bonded by a sulfide bond derived from a thiol bond in SH3. That is, it is considered that the polymer P-3 has four sulfide bonds.

The polymer P-4 is a polymer A including a constitutional unit derived from a tetrafunctional thiol compound SH4, and is a compound in which a molecular chain formed by the constitutional unit A1 to constitutional unit C1, and SH4 are respectively bonded by a sulfide bond derived from a thiol bond in SH4. That is, it is considered that the polymer P-4 has four sulfide bonds.

The polymers P-5 to P-12 are a polymer A including a constitutional unit derived from a hexafunctional thiol compound SH5, and is a compound in which a molecular chain formed by the constitutional unit A1 to constitutional unit C1, and SH5 are respectively bonded by a sulfide bond derived from a thiol bond in SH5. That is, it is considered that the polymers P-5 to P-12 has six sulfide bonds.

The image recording layer may singly contain one kind of the polymer A, or two or more kinds of thereof may be used in combination.

The content of the polymer A is preferably in a range of 5% by mass to 95% by mass, more preferably in a range of 7% by mass to 60% by mass, and more preferably in a range of 10% by mass to 30% by mass with respect to the total mass of the image recording layer.

### [Electron-accepting polymerization initiator]

It is preferable that the image recording layer includes an electron-accepting polymerization initiator.

The electron-accepting polymerization initiator used in the present disclosure is a compound which generates a polymerization-initiating species such as a radical and a cation using the energy of either or both light and heat, and it is possible to appropriately select and use a known thermal polymerization initiator, a compound having a bond with a small bond dissociation energy, a photopolymerization initiator, and the like.

As the electron-accepting polymerization initiator, a radical polymerization initiator is preferable and an onium salt compound is more preferable.

In addition, as the electron-accepting polymerization initiator, an infrared-photosensitive polymerization initiator is preferable.

The electron-accepting polymerization initiator may be used singly or two or more kinds thereof may be used in combination.

Examples of the radical polymerization initiator include (a) organic halide, (b) carbonyl compound, (c) azo compound, (d) organic peroxide, (e) metallocene compound, (f) azido compound, (g) hexaarylbiimidazole compound, (i) disulfone compound, (j) oxime ester compound, and (k) onium salt compound.

As the (a) organic halide, for example, a compound described in paragraphs 0022 and 0023 of JP2008-195018A is preferable.

As the (b) carbonyl compound, for example, a compound described in paragraph 0024 of JP2008-195018A is preferable.

As the (c) azo compound, for example, an azo compound described in JP1996-108621A (JP-H08-108621A) or the like can be used.

As the (d) organic peroxide, for example, a compound described in paragraph 0025 of JP2008-195018A is preferable.

As the (e) metallocene compound, for example, a compound described in paragraph 0026 of JP2008-195018A is preferable.

Examples of the (f) azido compound include a compound such as 2,6-bis(4-azidobenzylidene)-4-methylcyclohexanone.

As the (g) hexaarylbiimidazole compound, for example, a compound described in paragraph 0027 of JP2008-195018A is preferable.

Examples of the (i) disulfone compound include a compound described in each of JP1986-166544A (JP-S61-166544A) and JP2002-328465A.

As the (j) oxime ester compound, for example, a compound described in paragraphs 0028 to 0030 of JP2008-195018A is preferable.

From the viewpoint of curing properties, among the above-described electron-accepting polymerization initiators, an oxime ester compound and an onium salt compound are preferably exemplified. Among these, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds are described below, but the present disclosure is not limited thereto.

As examples of the iodonium salt compound, a diaryliodonium salt compound is preferable, a diphenyliodonium salt compound substituted with particularly an electron-donating group such as an alkyl group and an alkoxy group is more preferable, and an asymmetric diphenyliodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyliodonium=hexafluorophosphate, 4-hexyloxyphenyl-2,4-diethoxyphenyliodonium=tetrafluoroborate, 4-octyloxyphenyl-2,4,6-trimethoxyphenyliodonium= 1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As examples of the sulfonium salt compound, a triarylsulfonium salt compound is preferable, a triarylsulfonium salt compound substituted with particularly an electron-withdrawing group such as a group in which at least a part of group on an aromatic ring is substituted with a halogen atom is preferable, and a triarylsulfonium salt compound in which the total number of substituted halogen atoms on the aromatic ring is 4 or greater is more preferable. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

In addition, as a counter anion of the iodonium salt compound and the sulfonium salt compound, a sulfonamide anion or a sulfonimide anion is preferable, and a sulfonimide anion is more preferable.

As the sulfonamide anion, an arylsulfonamide anion is preferable.

In addition, as the sulfonimide anion, a bisarylsulfonimide anion is preferable.

Specific examples of the sulfonamide anion or the sulfonimide anion are described below, but the present disclosure is not limited thereto. In the specific examples, Ph represents a phenyl group, Me represents a methyl group, and Et represents an ethyl group, respectively.

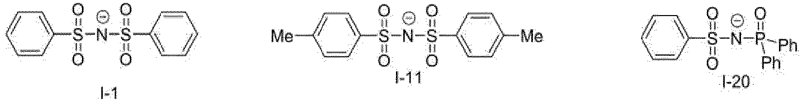

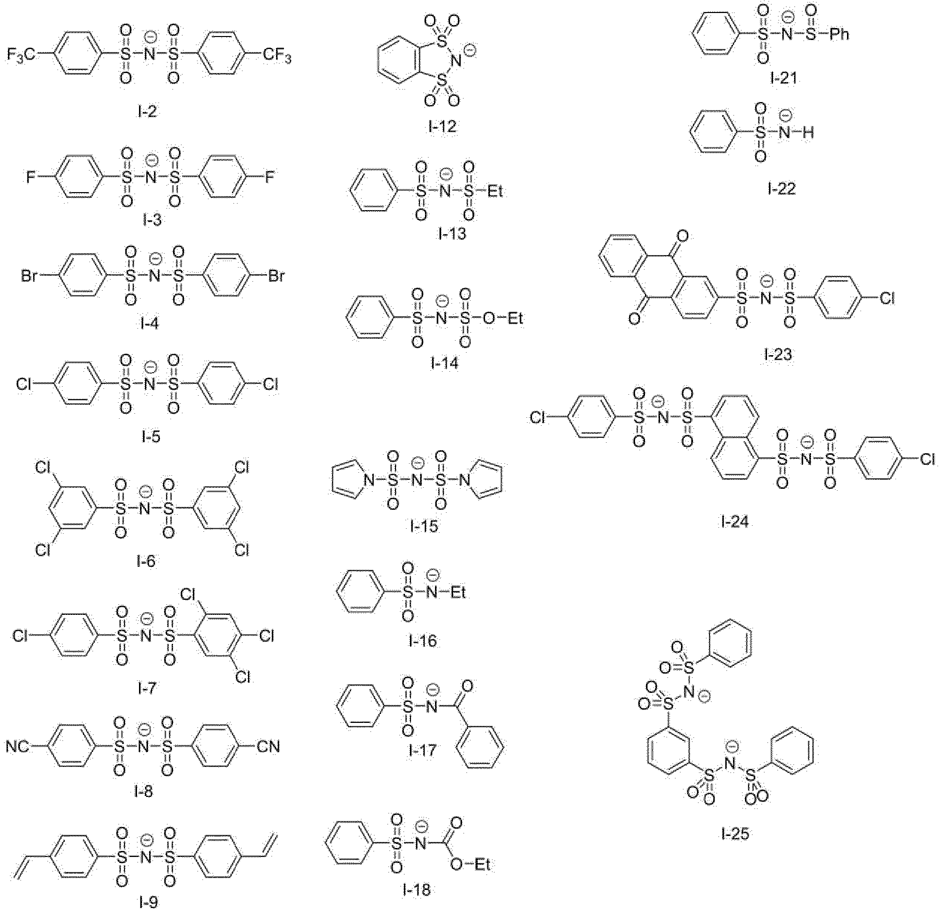

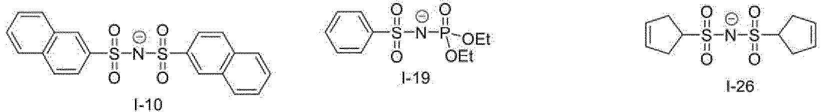

The content of the electron-accepting polymerization initiator is preferably in a range of 0.1% by mass to 50% by mass, more preferably in a range of 0.5% by mass to 30% by mass, and particularly preferably in a range of 0.8% by mass to 20% by mass of the total mass of the image recording layer.

### [Polymerizable compound]

It is preferable that the image recording layer in the present disclosure includes a polymerizable compound.

In the present disclosure, a compound which corresponds to the polymer A even in a case of having polymerizability does not correspond to the polymerizable compound.

The molecular weight (in a case of having a molecular weight distribution, weight-average molecular weight) of the polymerizable compound is preferably in a range of 50 or greater and less than 2,500, and more preferably in a range of 50 to 2,000.

The polymerizable compound used in the present disclosure may be, for example, a radical polymerizable compound or a cationic polymerizable compound, but is preferably an addition polymerizable compound (ethylenically unsaturated compound) having at least one ethylenically unsaturated bond. As the ethylenically unsaturated compound, a compound having at least one terminal ethylenically unsaturated bond is preferable and a compound having two or more terminal ethylenically unsaturated bonds is more preferable. The polymerizable compound has chemical forms such as a monomer, a pre-polymer, that is, a dimer, a trimer, or an oligomer, and a mixture of these.

Examples of the monomer include unsaturated carboxylic acids (such as acrylic acid, methacrylic acid, itaconic acid, crotonic acid, isocrotonic acid, and maleic acid), and esters and amides thereof, and esters of an unsaturated carboxylic acid and a polyhydric alcohol compound or amides of an unsaturated carboxylic acid and a polyhydric amine compound are preferably used. In addition, addition reaction products between unsaturated carboxylic acid esters or amides having a nucleophilic substituent such as a hydroxy group, an amino group, and a mercapto group, and monofunctional or polyfunctional isocyanates or epoxies, dehydration-condensation reaction products with monofunctional or polyfunctional carboxylic acids, and the like are also preferably used. In addition, addition reaction products between unsaturated carboxylic acid esters or amides having an electrophilic substituent such as an isocyanate group and an epoxy group, and monofunctional or polyfunctional alcohols, amines, or thiols, and substitution reaction products between unsaturated carboxylic acid esters or amides having a dissociable substituent such as a halogen atom and a tosyloxy group, and monofunctional or polyfunctional alcohols, amines, or thiols are also suitable. In addition, as additional examples, compound groups obtained by replacing the above-described unsaturated carboxylic acids with unsaturated phosphonic acids, styrene, vinyl ethers, or the like can also be used. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-064130A, JP2003-280187A, JP1998-333321A (JP-H10-333321A), and the like.

As specific examples of monomers of esters of polyhydric alcohol compounds and unsaturated carboxylic acids, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, polyester acrylate oligomers, and the like are exemplified as acrylic acid esters. As methacrylic acid esters, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, bis[p-(methacryloxyethoxy)phenyl] dimethyl methane, and the like are exemplified. In addition, as specific examples of monomers of amides of polyhydric amine compounds and unsaturated carboxylic acids, methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like are exemplified.

In addition, urethane-based addition polymerizable compounds produced using an addition reaction between an isocyanate and a hydroxy group are also suitable, and specific examples thereof include vinyl urethane compounds having two or more polymerizable vinyl groups in one molecule obtained by adding vinyl monomers having a hydroxy group represented by Formula (M) to a polyisocyanate compound having two or more isocyanate groups in one molecule which is described in JP1973-041708B (JP-S48-041708B).

CH₂=C(R^{M4})COOCH₂CH(R^{M5})OH (M)

In Formula (M), R^{M4} and R^{M5} each independently represent a hydrogen atom or a methyl group.

In addition, urethane acrylates described in JP1976-037193A (JP-S51-037193A), JP1990-32293B (JP-H02-32293B), JP1990-16765B (JP-H02-16765B), JP2003-344997A, and JP2006-065210A, urethane compounds having ethylene oxide-based skeletons described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-094138A, and urethane compounds having hydrophilic groups described in US7153632B, JP1996-505958A (JP-H08-505958A), JP2007-293221A, and JP2007-293223A are also suitable.

The details of the structures of these polymerizable compounds, whether to be used alone or in combination, and the usage method such as the addition amount can be optionally set.

The content of the polymerizable compound is preferably in a range of 5% by mass to 75% by mass, more preferably in a range of 10% by mass to 70% by mass, and particularly preferably in a range of 15% by mass to 60% by mass of the total mass of the image recording layer.

### [Infrared absorbent]

It is preferable that the image recording layer includes an infrared absorbent.

Examples of the infrared absorbent include a pigment and a dye.

As the dye used as the infrared absorbent, it is possible to use a commercially available dye and a known dye, for example, described in publications of "Dye Handbooks" (edited by the Society of Synthetic Organic Chemistry, Japan and published on 1970) and the like. Specifically, dyes such as an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium coloring agent, a pyrylium salt, and a metal thiolate complex are exemplified.

Among these dyes, a cyanine coloring agent, a squarylium coloring agent, a pyrylium salt, a nickel thiolate complex, and an indolenine cyanine coloring agent are particularly preferably exemplified. Furthermore, a cyanine coloring agent and an indolenine cyanine coloring agent are exemplified. Among these, a cyanine coloring agent is particularly preferable.

As specific examples of the cyanine coloring agent, a compound described in paragraphs 0017 to 0019 of JP2001-133969A, a compound described in paragraphs 0016 to 0021 of JP2002-023360A and paragraphs 0012 to 0037 of JP2002-040638A, preferably a compound described in paragraphs 0034 to 0041 of JP2002-278057A and paragraphs 0080 to 0086 of JP2008-195018A, and particularly preferably a compound described in paragraphs 0035 to 0043 of JP2007-090850A and a compound described in paragraphs 0105 to 0113 of JP2012-206495A are exemplified.

In addition, a compound described in paragraphs 0008 and 0009 of JP1993-005005A (JP-H05-005005A) and paragraphs 0022 to 0025 of JP2001-222101A can be also preferably used.

As the pigment, a compound described in paragraphs 0072 to 0076 of JP2008-195018Ais preferable.

The infrared absorbent may be used alone or in combination of two or more kinds thereof. In addition, as the infrared absorbent, the pigment and the dye may be used in combination.

The content of the infrared absorbent in the image recording layer is preferably in a range of 0.1% by mass to 10.0% by mass and more preferably in a range of 0.5% by mass to 5.0% by mass with respect to the total mass of the image recording layer.

### [Acid color developing agent]

It is preferable that the image recording layer used in the present disclosure includes an acid color developing agent.

The "acid color developing agent" used in the present disclosure means a compound having a property of developing color by heating while receiving an electron-accepting compound (for example, a proton such as an acid). In particular, the acid color developing agent is preferably a colorless compound which has a partial skeleton such as lactone, lactam, sultone, spiropyran, ester, or amide, and in which the partial skeleton rapidly ring-opens or cleavages in a case of coming into contact with the electron-accepting compound.

Examples of such an acid color developing agent include phthalides such as 3,3-bis(4-dimethylaminophenyl)-6-dimethylaminophthalide (referred to as a "crystal violet lactone"), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl)phthalide, 3-(4-dimethylaminophenyl)-3-(2-methylindol-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazole-3-yl)-6-dimethylaminophthalide, 3,3-bis(2-phenylindol-3-yl)-6-dimethylaminophthalide, 3-(4-dimethylaminophenyl)-3-(1-methylpyrrole-3-yl)-6-dimethylaminophthalide,

3,3-bis[1,1-bis(4-dimethylaminophenyl)ethylene-2-yl]-4,5,6,7-tetrachlorophthalide, 3,3-bis[1,1-bis(4-pyrrolidinophenyl)ethylene-2-yl]-4,5,6,7-tetrabromophthalide, 3,3-bis[1-(4-dimethylaminophenyl)-1-(4-methoxyphenyl)ethylene-2-yl]-4,5,6,7-tetrachloropht halide, 3,3-bis[1-(4-pyrrolidinophenyl)-1-(4-methoxyphenyl)ethylene-2-yl]-4,5,6,7-tetrachlorophthali de, 3-[1,1-di(1-ethyl-2-methylindol-3-yl)ethylene-2-yl]-3-(4-diethylaminophenyl)phthalide, 3-[1,1-di(1-ethyl-2-methylindol-3-yl)ethylene-2-yl]-3-(4-N-ethyl-N-phenylaminophenyl)phtha lide, 3-(2-ethoxy-4-diethylaminophenyl)-3-(1-n-octyl-2-methylindol-3-yl)-phthalide, 3,3-bis(1-n-octyl-2-methylindol-3-yl)-phthalide, and 3-(2-methyl-4-diethylaminophenyl)-3-(1-n-octyl-2-methylindol-3-yl)-phthalide;

fluoranthenes such as 4,4-bis-dimethylaminobenzhydryl benzyl ether, N-halophenyl-leucoauramine, N-2,4,5-trichlorophenylleucoauramine, rhodamine-B-anilinolactam, rhodamine-(4-nitroanilino) lactam, rhodamine-B-(4-chloroanilino) lactam, 3,7-bis(diethylamino)-10-benzoylphenoxazine, benzoyl leuco methylene blue, 4-nitrobenzoylmethylene blue,

3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluorane, 3-di-n-butylamino-7-(2'-fluorophenylamino)fluoran, 3-di-n-butylamino-7-(2'-chlorophenylamino)fluoran, 3-N-isopentyl-N-ethylamino-7-(2'-chlorophenylamino)fluorane,

3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-piperidino-6-methyl-7-anilinofluoran, 3-morpholino-6-methyl-7-anilinofluoran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-ethylamino-6-methyl-7-anilinofluoran, 3-N-isobutyl-N-ethylamino-6-methyl-7-anilinofluoran, 3-N-isopentyl-N-methylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran,

3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3'-methoxypropyl)-N-methylamino-6-methyl-7-anilinofluoran, 3-N-(3'-methoxypropyl)-N-ethylamino-6-methyl-7-anilinofluoran, 3-N-(3'-ethoxypropyl)-N-ethylamino-6-methyl-7-anilinofluoran, 3-N-(3'-ethoxypropyl)-N-methylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-methyl-7-anilinofluran, 3-diethylamino-6-methyl-7-(3'-methylphenylamino)fluoran, 3-diethylamino-6-methyl-7-(2',6'-methylphenylamino)fluoran, 3-di-n-butylamino-6-methyl-7-(2',6'-methylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'-(dimethylaminophenyl)] amino-5,7-dimethylfluoran;

phthalides such as 3-(2-methyl-4-diethylaminophenyl)-3-(1-ethyl-2-methylindol-3-yl)-4-azaphthalide, 3-(2-n-propoxycarbonylamino-4-di-n-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4 or 7-azaphthalide, 3-(2-ethoxy-4-diethylaminophenyl)-3-(1-ethyl-2-methylindol-3-yl)-4 or 7-azaphthalide, 3-(2-hexyloxy-4-diethylaminophenyl)-3-(1-ethyl-2-methylindol-3-yl)-4 or 7-azaphthalide, 3-(2-ethoxy-4-diethylaminophenyl)-3-(1-ethyl-2-phenylindol-3-yl)-4 or 7-azaphthalide, 3-(2-butoxy-4-diethylaminophenyl)-3-(1-ethyl-2-phenylindol-3-yl)-4 or 7-azaphthalide 3-methyl-spiro-dinaphthopyran, 3-ethyl-spiro-dinaphthopyran, 3-phenyl-spiro-dinaphthopyran, 3-benzyl-spiro-dinaphthopyran, 3-methylnaphtho-(3-methoxybenzo)spiropyran, 3-propyl-spiro-dibenzopyran-3,6-bis(dimethylamino)fluorene-9-spiro-3'-(6'-dimethylamino)p hthalide, and 3,6-bis(diethylamino)fluorene-9-spiro-3'-(6'-dimethylamino)phthalide; and

2'-anilino-6'-(N-ethyl-N-isopentyl)amino-3'-methylspiro[isobenzofuran-1(3H),9'-(9H) xanthene]-3-one, 2'-anilino-6'-(N-ethyl-N-(4-methylphenyl))amino-3'-methylspiro [isobenzofuran-1(3H),9' -(9H) xanthene]-3-one, 3'-N,N-dibenzylamino-6'-N,N-diethylaminospiro[isobenzofuran-1(3H),9'-(9H) xanthene]-3-one, and 2'-(N-methyl-N-phenyl)amino-6'-(N-ethyl-N-(4-methylphenyl)) aminospiro [i sob enzofuran- 1 (3 H), 9'-(9H) xanthene]-3-one.

Among these, from the viewpoint of color developability, the acid color developing agent used in the present disclosure is preferably at least one compound selected from the group consisting of a spiropyran compound, a spirooxazine compound, a spirolactone compound, and a spirolactam compound.

From the viewpoint of visibility, the color tone of the coloring agent after color development is preferably green, blue, or black.

Commercially available products can also be used as the acid color developing agent, and examples thereof include ETAC, RED 500, RED 520, CVL, S-205, BLACK 305, BLACK 400, BLACK 100, BLACK 500, H-7001, GREEN 300, NIRBLACK 78, BLUE 220, H-3035, BLUE 203, ATP, H-1046, H-2114 (all manufactured by Fukui Yamada Chemical Co., Ltd.), ORANGE-DCF, Vermilion-DCF, PINK-DCF, RED-DCF, BLMB, CVL, GREEN-DCF, TH-107 (all manufactured by Hodogaya Chemical Co., Ltd.), ODB, ODB-2, ODB-4, ODB-250, ODB-Black XV, Blue-63, Blue-502, GN-169, GN-2, Green-118, Red-40, Red-8 (all manufactured by Yamamoto Chemicals Inc.), and crystal violet lactone (manufactured by Tokyo Chemical Industry Co., Ltd.). Among these commercially available products, since visible light absorbance of the film to be formed is good, ETAC, S-205, BLACK 305, BLACK 400, BLACK 100, BLACK 500, H-7001, GREEN 300, NIRBLACK 78, H-3035, ATP, H-1046, H-2114, GREEN-DCF, Blue-63, GN-169, or crystal violet lactone is preferable.

These acid color developing agents may be used alone or two or more components thereof can be used in combination.

The content of the acid color developing agent is preferably in a range of 0.5% by mass to 10% by mass and more preferably in a range of 1% by mass to 5% by mass with respect to the total mass of the image recording layer.

### [Polymer particles]

It is preferable that the image recording layer includes polymer particles.

It is preferable that the polymer particles are selected from the group consisting of thermoplastic polymer particles, thermally reactive polymer particles, polymer particles having a polymerizable group, a microcapsule encapsulating a hydrophobic compound, and a microgel (cross-linked polymer particles). Among these, polymer particles having a polymerizable group or a microgel is preferable. According to a particularly preferred embodiment, the polymer particles include at least one ethylenically unsaturated polymerizable group. Because of the presence of the polymer particles, the effects of improving printing durability of an exposed area and on-press developability of an unexposed area are obtained.

In addition, it is preferable that the polymer particles are thermoplastic polymer particles.

Preferred examples of the thermoplastic polymer particles include thermoplastic polymer particles described in Research Disclosure No. 33303 on January, 1992, JP1997-123387A (JP-H09-123387A), JP1997-131850A (JP-H09-131850A), JP1997-171249A (JP-H09-171249A), JP1997-171250A (JP-H09-171250A), and EP931647B.

Specific examples of a polymer constituting the thermoplastic polymer particles include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures of these. Among these, polystyrene, styrene, a copolymer containing acrylonitrile, or polymethylmethacrylate is more preferable. The average particle diameter of the thermoplastic polymer particles is preferably in a range of 0.01 µm to 3.0 µm.

Examples of the thermally reactive polymer particles include polymer particles having a thermally reactive group. The thermally reactive polymer particles are cross-linked by a thermal reaction and have hydrophobic regions formed by a change in functional groups during the cross-linking.

As the thermally reactive group in polymer particles having a thermally reactive group, a functional group that performs any reaction may be used as long as a chemical bond is formed, but a polymerizable group is preferable. Preferred examples of the polymerizable group include an ethylenically unsaturated group that performs a radical polymerization reaction (such as an acryloyl group, a methacryloyl group, a vinyl group, or an allyl group); a cationic polymerizable group (such as a vinyl group, a vinyloxy group, an epoxy group, or an oxetanyl group); an isocyanate group that performs an addition reaction or a block body thereof, an epoxy group, a vinyloxy group, and a functional group having an active hydrogen atom as a reaction partner of these (such as an amino group, a hydroxy group, or a carboxy group); a carboxy group that performs a condensation reaction and a hydroxy group or an amino group as a reaction partner thereof; and an acid anhydride that performs a ring-opening addition reaction and an amino group or a hydroxy group as a reaction partner thereof.

The microcapsule is a microcapsule in which at least a part of constituent components of the image recording layer is encapsulated as described in JP2001-277740A and JP2001-277742A. The constituent components of the image recording layer may be contained in a portion other than the microcapsule. A preferred aspect of the image recording layer containing the microcapsule is an aspect in which hydrophobic constituent components are encapsulated in a microcapsule and hydrophilic constituent components are contained in a portion other than the microcapsule.

The microgel (cross-linked polymer particles) may contain a part of the constituent components of the image recording layer in at least one of the surface or the inside of the microgel. From the viewpoints of image forming sensitivity and printing durability, a reactive microgel having a radical polymerizable group on the surface thereof is particularly preferable.

The constituent components of the image recording layer can be made into microcapsules or microgels using a known method.

From the viewpoint of printing durability, stain resistance, and storage stability, it is preferable that the polymer particles are obtained by reacting a polyvalent isocyanate compound which is an adduct of a polyhydric phenol compound containing two or more hydroxy groups in a molecule and isophorone diisocyanate with a compound containing an active hydrogen.

As the polyhydric phenol compound, a compound having a plurality of benzene rings containing a phenolic hydroxy group is preferable.

As the compound having an active hydrogen, a polyol compound or a polyamine compound is preferable, a polyol compound is more preferable, and at least one compound selected from the group consisting of propylene glycol, glycerin, and trimethylolpropane is still more preferable.

As the resin particles obtained by reacting the compound containing an active hydrogen with the polyvalent isocyanate compound which is an adduct of a polyhydric phenol compound containing two or more hydroxy groups in a molecule and isophorone diisocyanate, polymer particles described in paragraphs 0032 to 0095 of JP2012-206495A are preferably exemplified.

Furthermore, from the viewpoint of printing durability and solvent resistance, it is preferable that the polymer particles have a hydrophobic main chain and both of a constitutional unit (i) which contains a pendant-cyano group directly bonded to the hydrophobic main chain and a constitutional unit (ii) which contains a pendant group having a hydrophilic polyalkylene oxide segment.

Preferred examples of the hydrophobic main chain include an acrylic resin chain.

Preferred examples of the pendant-cyano group include -[CH₂CH(C≡N)-] and -[CH₂C(CH₃)(C≡N)-].

In addition, a constitutional unit having the pendant-cyano group can be easily derived from an ethylene-based unsaturated monomer such as acrylonitrile or methacrylonitrile or a combination of these.

In addition, as the alkylene oxide in the hydrophilic polyalkylene oxide segment, ethylene oxide or propylene oxide is preferable and ethylene oxide is more preferable.

The repetition number of alkylene oxide structures in the hydrophilic polyalkylene oxide segment is preferably in a range of 10 to 100, more preferably in a range of 25 to 75, and still more preferably in a range of 40 to 50.

As the resin particles which have a hydrophobic main chain and both of a constitutional unit (i) containing a pendant-cyano group directly bonded to the hydrophobic main chain and a constitutional unit (ii) containing a pendant group having a hydrophilic polyalkylene oxide segment, those described in paragraphs 0039 to 0068 of JP2008-503365A are preferably exemplified.

The average particle diameter of the polymer particles is preferably in a range of 0.01 µm to 3.0 µm, more preferably in a range of 0.03 µm to 2.0 µm, and still more preferably in a range of 0.10 µm to 1.0 µm. In a case where the average particle diameter thereof is within the above-described range, excellent resolution and temporal stability are obtained.

The average primary particle diameter of each of the particles in the present disclosure is measured by a light scattering method, or is obtained by imaging an electron micrograph of the particles, measuring the total number of 5,000 particle diameters of the particles on the photograph, and calculating an average value thereof. Regarding non-spherical particles, a particle diameter value of spherical particles which have the same particle area with the particle area on the photograph is set to a particle diameter of the non-spherical particles.

In addition, unless otherwise specified, the average particle diameter in the present disclosure is a volume average particle diameter.

The content of the polymer particles is preferably in a range of 5% by mass to 90% by mass with respect to the total mass of the image recording layer.

### [Electron-donating polymerization initiator]

It is preferable that the image recording layer used in the present disclosure contains an electron-donating polymerization initiator. The electron-donating polymerization initiator contributes to improvement of printing durability of the planographic printing plate. As the electron-donating polymerization initiator, for example, the following five types are exemplified.
(i) Alkyl or arylate complex: It is considered that a carbon-hetero bond is oxidatively cleaved, and an active radical is generated. Specifically, a borate compound is exemplified.
(ii) Aminoacetic acid compound: It is considered that a C-X bond on carbon adjacent to a nitrogen is cleaved by oxidation, and an active radical is generated. As X, a hydrogen atom, a carboxy group, a trimethylsilyl group, or a benzyl group is preferable. Specifically, N-phenylglycines (which may have a substituent in a phenyl group), N-phenyl iminodiacetic acid (which may have a substituent in a phenyl group), and the like are exemplified.
(iii) Sulfur-containing compound: A compound in which a nitrogen atom in the above-described aminoacetic acid compound is replaced with a sulfur atom can generate an active radical by the same action. Specifically, phenylthioacetic acid (which may have a substituent in a phenyl group) and the like are exemplified.
(iv) Tin-containing compound: A compound in which a nitrogen atom in the above-described aminoacetic acid compound is replaced with a tin atom can generate an active radical by the same action.
(v) Sulfinates: An active radical can be generated by oxidation. Specifically, sodium arylsulfinate and the like are exemplified.

Among these electron-donating polymerization initiators, it is preferable that the image recording layer contains a borate compound. As the borate compound, a tetraaryl borate compound or a monoalkyltriaryl borate compound is preferable, and from the viewpoint of stability of the compound, a tetraaryl borate compound is more preferable and a tetraphenyl borate compound is particularly preferable.

A counter cation of the borate compound is not particularly limited, but an alkali metal ion or a tetraalkyl ammonium ion is preferable and a sodium ion, a potassium ion, or a tetrabutyl ammonium ion is more preferable.

Preferred specific examples of the borate compound include sodium tetraphenyl borate.

Preferred specific examples of the electron-donating polymerization initiator are described below as B-1 to B-9, but needless to say, the electron-donating polymerization initiator is not limited thereto. In addition, in the following formulae, Ph represents a phenyl group and Bu represents an n-butyl group.

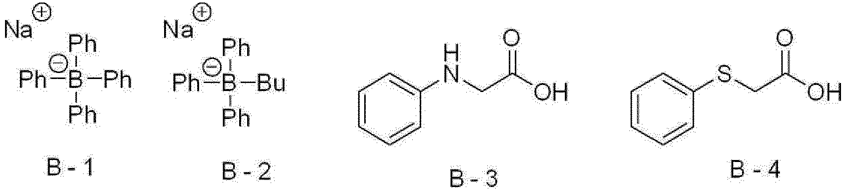

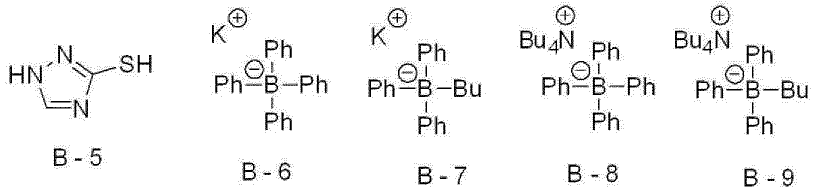

The electron-donating polymerization initiator may be singly added or may be used in combination of two or more kinds thereof.

The content of the electron-donating polymerization initiator is preferably in a range of 0.01% by mass to 30% by mass, more preferably in a range of 0.05% by mass to 25% by mass, and still more preferably in a range of 0.1% by mass to 20% by mass with respect to the total mass of the image recording layer.

### [Binder polymer]

The image recording layer may include a binder polymer other than the polymer A.

A polymer corresponding to the polymer A does not correspond to the binder polymer. That is, the binder polymer in the present disclosure is a polymer satisfying one or two of the following conditions (1) and (2).
(1) The weight-average molecular weight is greater than 35,000.
(2) The content of the constitutional unit A1 including an ethylenically unsaturated group is less than 15 mol%.

As the binder polymer, a (meth)acrylic resin, a polyvinyl acetal resin, or a polyurethane resin is preferable.

Among these, a known binder polymer used for an image recording layer of a planographic printing plate precursor can be suitably used as the binder polymer. As an example, a binder polymer which is used for the on-press development type planographic printing plate precursor (hereinafter, also referred to as a binder polymer for on-press development) will be described in detail.

The binder polymer for on-press development is preferably a binder polymer having an alkylene oxide chain. The binder polymer having an alkylene oxide chain may have a poly(alkylene oxide) moiety in the main chain or in the side chain. In addition, the binder polymer may be a graft polymer having a poly(alkylene oxide) in the side chain or a block copolymer of a block constituted of a constitutional unit containing a poly(alkylene oxide) and a block constituted of a constitutional unit not containing a poly(alkylene oxide).

In a case where the binder polymer has a poly(alkylene oxide) moiety in the main chain, a polyurethane resin is preferable. Examples of a main chain of the polymer in a case where the binder polymer has a poly(alkylene oxide) moiety in the side chain include a (meth)acrylic resin, a polyvinyl acetal resin, a polyurethane resin, a polyurea resin, a polyimide resin, a polyamide resin, an epoxy resin, a polystyrene resin, a novolac-type phenolic resin, a polyester resin, synthetic rubber, and natural rubber, and a (meth)acrylic resin is particularly preferable.

In addition, other preferred examples of the binder polymer include a polymer compound (hereinafter, also referred to as a "star polymer compound") which has a polymer chain bonded to a nucleus through a sulfide bond by means of using a polyfunctional, in a range of hexa- to deca-functional, thiol as the nucleus and in which the polymer chain has a polymerizable group. As the star polymer compound, for example, compounds described in JP2012-148555Acan be preferably used.

Examples of the star polymer compound include compounds having a polymerizable group such as an ethylenically unsaturated bond in the main chain or in the side chain, preferably in the side chain, for improving coated-film hardness of an image area as described in JP2008-195018A. Cross-linking occurs between polymer molecules by a polymerizable group so that curing is promoted.

Preferred examples of the polymerizable group include an ethylenically unsaturated group such as a (meth)acrylic group, a vinyl group, an allyl group, or a styryl group and an epoxy group. Among these, from the viewpoint of polymerization reactivity, a (meth)acrylic group, a vinyl group, or a styryl group is more preferable and a (meth)acrylic group is particularly preferable. These groups can be introduced into a polymer by a polymer reaction or copolymerization. For example, a reaction between a polymer having a carboxy group in the side chain thereof and glycidyl methacrylate or a reaction between a polymer having an epoxy group and ethylenically unsaturated group-containing carboxylic acid such as methacrylic acid can be used. These groups may be used in combination.

Regarding the molecular weight of the binder polymer, the weight-average molecular weight (Mw) in terms of polystyrene value by a GPC method is preferably 2,000 or greater, more preferably 5,000 or greater, and still more preferably in a range of 10,000 to 300,000.

It is possible to use in combination with hydrophilic polymers such as polyacrylic acid and polyvinyl alcohol described in JP2008-195018A as necessary. In addition, it is also possible to use in combination with a lipophilic polymer and a hydrophilic polymer.

In the image recording layer used in the present disclosure, the binder polymer may be used alone or in combination of two or more kinds thereof.

The binder polymer can be contained in an optional amount in the image recording layer, but the content of the binder polymer is preferably in a range of 1% by mass to 90% by mass and more preferably in a range of 5% by mass to 80% by mass with respect to the total mass of the image recording layer.

In addition, in the image recording layer in the present disclosure, the content of the binder polymer, with respect to the total mass of the polymer A and the binder polymer, is preferably in a range of 0% by mass to 99% by mass, more preferably in a range of 20% by mass to 95% by mass, and still more preferably in a range of 40% by mass to 90% by mass.

### [Chain transfer agent]

The image recording layer used in the present disclosure may contain a chain transfer agent. The chain transfer agent contributes to improvement of printing durability of the planographic printing plate.

The chain transfer agent is preferably a thiol compound, and from the viewpoint of the boiling point (difficulty of being volatilized), more preferably a thiol compound having 7 or more carbon atoms and still more preferably a compound (aromatic thiol compound) having a mercapto group on an aromatic ring. The thiol compound is preferably a monofunctional thiol compound.

Specific examples of the chain transfer agent include the following compounds.

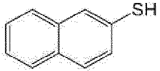

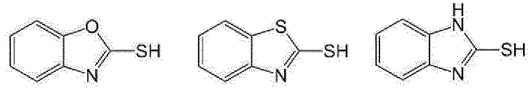

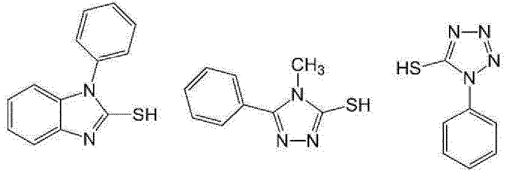

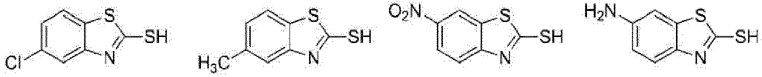

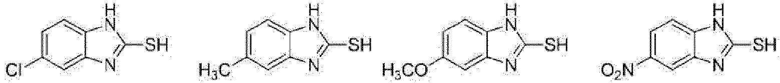

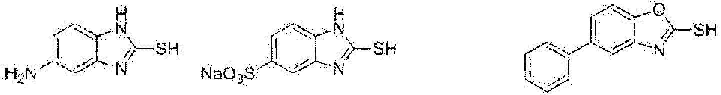

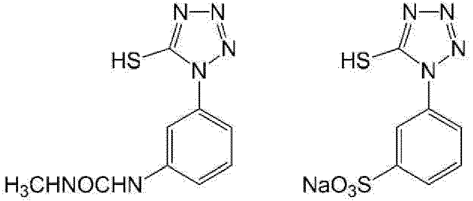

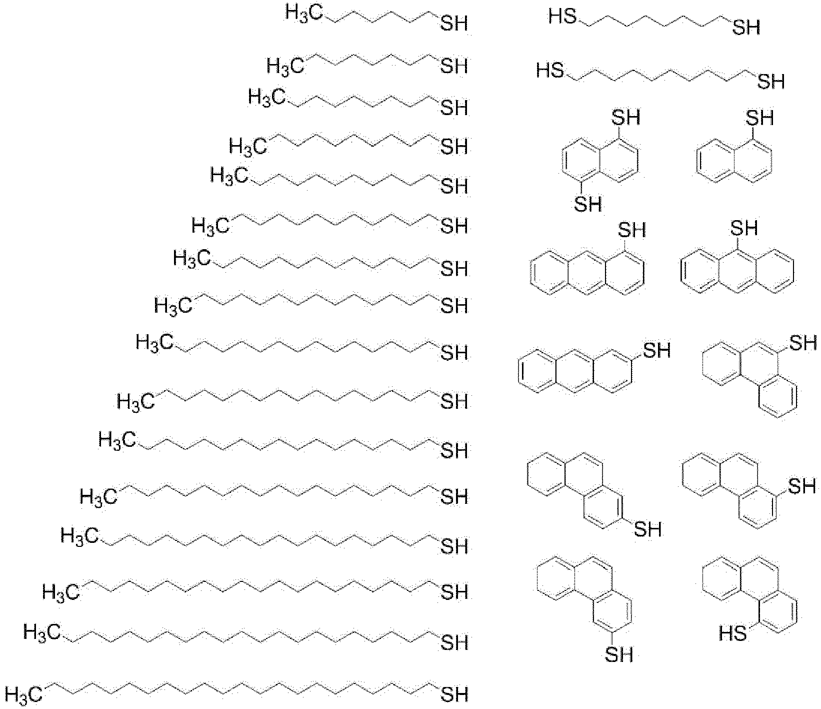

The chain transfer agent may be singly added or may be used in combination of two or more kinds thereof.

The content of the chain transfer agent is preferably in a range of 0.01% by mass to 50% by mass, more preferably in a range of 0.05% by mass to 40% by mass, and still more preferably in a range of 0.1% by mass to 30% by mass with respect to the total mass of the image recording layer.

### [Low-molecular weight hydrophilic compound]

In order to improve on-press developability while suppressing a degradation in printing durability, the image recording layer may contain a low-molecular weight hydrophilic compound. The low-molecular weight hydrophilic compound is preferably a compound having a molecular weight of less than 1,000, more preferably a compound having a molecular weight of less than 800, and still more preferably a compound having a molecular weight of less than 500.

Examples of the low-molecular weight hydrophilic compound include a water-soluble organic compound. Examples of the water-soluble organic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

It is preferable that the low-molecular weight hydrophilic compound contains at least one selected from the group consisting of polyols, organic sulfates, organic sulfonates, and betaines.

Specific examples of the organic sulfonates include alkyl sulfonates such as sodium n-butyl sulfonate, sodium n-hexyl sulfonate, sodium 2-ethylhexyl sulfonate, sodium cyclohexyl sulfonate, and sodium n-octyl sulfonate; alkyl sulfonates having an ethylene oxide chain, such as sodium 5,8,11-trioxapentadecane-1-sulfonate, sodium 5,8, 11-trioxaheptadecane-1-sulfonate, sodium 13-ethyl-5,8,11-trioxaheptadecane-1-sulfonate, and sodium 5,8,11,14-tetraoxatetracosane-1-sulfonate; aryl sulfonates such as sodium benzene sulfonate, sodium p-toluenesulfonate, sodium p-hydroxybenzene sulfonate, sodium p-styrene sulfonate, sodium dimethyl isophthalate-5-sulfonate, sodium 1-naphthyl sulfonate, sodium 4-hydroxynaphthylsulfonate, sodium 1,5-naphthalene disulfonate, and trisodium 1,3,6-naphthalene trisulfonate; and compounds described in paragraphs 0026 to 0031 of JP2007-276454A and paragraphs 0020 to 0047 of JP2009-154525A. The salt may be potassium salts or lithium salts.

Examples of the organic sulfates include sulfates of alkyls, alkenyls, alkynyls, aryls, and heterocyclic monoethers in polyethylene oxides. The number of ethylene oxide units is preferably 1 to 4, and the salt is preferably a sodium salt, a potassium salt, or a lithium salt. Specific examples thereof include compounds described in paragraphs 0034 to 0038 of JP2007-276454A.

As the betaines, compounds in which a hydrocarbon substituent to a nitrogen atom has 1 to 5 carbon atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the low-molecular weight hydrophilic compound has a small structure in a hydrophobic portion and barely has surfactant action, hydrophobicity or coated-film hardness of an image area is not degraded by dampening water permeating into an image recording layer exposed area (image area) and ink receptivity or printing durability of the image recording layer can be maintained satisfactorily.

The content of the low-molecular weight hydrophilic compound is preferably in a range of 0.5% by mass to 20% by mass, more preferably in a range of 1% by mass to 15% by mass, and still more preferably in a range of 2% by mass to 10% by mass with respect to the total mass of the image recording layer. In a case where the amount thereof is within the above-described range, excellent on-press developability and printing durability can be obtained.

The low-molecular weight hydrophilic compound may be used alone or in combination of two or more kinds thereof.

### [Oil sensitizing agent]

In order to improve impressing property, the image recording layer may contain an oil sensitizing agent such as a phosphonium compound, a nitrogen-containing low-molecular weight compound, or an ammonium group-containing polymer. In particular, in a case where a protective layer contains an inorganic layered compound, the above-described compounds function as a surface coating agent of the inorganic layered compound and can suppress a degradation in impressing property during printing due to the inorganic layered compound.

As the oil sensitizing agent, a phosphonium compound, a nitrogen-containing low-molecular weight compound, and an ammonium group-containing polymer are preferably used in combination, and a phosphonium compound, quaternary ammonium salts, and an ammonium group-containing polymer are more preferably used in combination.

Examples of the phosphonium compound include phosphonium compounds described in JP2006-297907A and JP2007-050660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate.

Examples of the nitrogen-containing low-molecular weight compound include amine salts and quaternary ammonium salts. In addition, examples thereof include imidazolinium salts, benzo imidazolinium salts, pyridinium salts, and quinolinium salts. Among these, quaternary ammonium salts and pyridinium salts are preferable. Specific examples thereof include tetramethylammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, and compounds described in paragraphs 0021 to 0037 of JP2008-284858A and paragraphs 0030 to 0057 of JP2009-090645A.

The ammonium group-containing polymer is not limited as long as an ammonium group is included in the structure thereof, and polymers containing 5 mol% to 80 mol% of (meth)acrylate having an ammonium group in the side chain as a copolymerization component are preferable. Specific examples thereof include polymers described in paragraphs 0089 to 0105 of JP2009-208458A.

In the ammonium group-containing polymer, the value of reduced specific viscosity (unit: ml/g) obtained according to the measuring method described in JP2009-208458A is preferably in a range of 5 to 120, more preferably in a range of 10 to 110, and particularly preferably in a range of 15 to 100. In a case where the reduced specific viscosity is converted to the weight-average molecular weight (Mw), the weight-average molecular weight is preferably in a range of 10,000 to 150,000, more preferably in a range of 17,000 to 140,000, and particularly preferably in a range of 20,000 to 130,000.

Specific examples of the ammonium group-containing polymer will be described below.
(1) 2-(trimethylammonio)ethyl methacrylate=p-toluene sulfonate/3,6-dioxaheptyl methacrylate copolymer (molar ratio: 10/90, Mw: 45,000)
(2) 2-(trimethylammonio)ethyl methacrylate=hexafluorophosphate/3,6-dioxaheptyl methacrylate copolymer (molar ratio: 20/80, Mw: 60,000)
(3) 2-(ethyldimethylammonio)ethyl methacrylate=p-toluene sulfonate/hexyl methacrylate copolymer (molar ratio: 30/70, Mw: 45,000)
(4) 2-(trimethylammonio)ethyl methacrylate=hexafluorophosphate/2-ethylhexyl methacrylate copolymer (molar ratio: 20/80, Mw: 60,000)
(5) 2-(trimethylammonio)ethyl methacrylate=methylsulfate/hexyl methacrylate copolymer (molar ratio: 40/60, Mw: 70,000)
(6) 2-(butyldimethylammonio)ethyl methacrylate=hexafluorophosphate/3,6-dioxaheptyl methacrylate copolymer (molar ratio: 25/75, Mw: 65,000)
(7) 2-(butyldimethylammonio)ethyl acrylate=hexafluorophosphate/3,6-dioxaheptyl methacrylate copolymer (molar ratio: 20/80, Mw: 65,000)
(8) 2-(butyldimethylammonio)ethyl methacrylate=13-ethyl-5,8,11-trioxa-1-heptadecanesulfonate/3,6-dioxaheptyl methacrylate copolymer (molar ratio: 20/80, Mw: 75,000)
(9) 2-(butyldimethylammonio)ethyl methacrylate=hexafluorophosphate/3,6-dioxaheptyl methacrylate/2-hydroxy-3-methacryloyloxypropyl methacrylate copolymer (molar ratio: 15/80/5, Mw: 65,000)

The content of the oil sensitizing agent is preferably in a range of 0.01% by mass to 30.0% by mass, more preferably in a range of 0.1% by mass to 15.0% by mass, and still more preferably in a range of 1% by mass to 10% by mass with respect to the total mass of the image recording layer.

### [Other components]

The image recording layer can contain, as other components, a surfactant, a polymerization inhibitor, a higher fatty acid derivative, a plasticizer, inorganic particles, an inorganic layered compound, and the like. Specifically, the description in paragraphs 0114 to 0159 of JP2008-284817A can be referred to.

### [Formation of image recording layer]

For example, the image recording layer in the planographic printing plate precursor according to the embodiment of the present disclosure can be formed by dispersing or dissolving each of the above-described required components in a known solvent to prepare a coating solution, coating a support with the coating solution using a known method such as a bar coater coating method, and drying the resultant, as described in paragraphs 0142 and 0143 of JP2008-195018A. The coating amount (solid content) of the image recording layer after the coating and the drying varies depending on the applications thereof, but is preferably in a range of 0.3 g/m² to 3.0 g/m². In a case where the coating amount thereof is within the above-described range, excellent sensitivity and excellent film-coating characteristics of the image recording layer are obtained.

As the solvent, a known solvent can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate. The solvent may be used alone or in combination of two or more kinds thereof. The concentration of solid contents in the coating solution is preferably in a range of approximately 1% to 50% by mass.

The coating amount (solid content) of the image recording layer after the coating and the drying varies depending on the applications thereof, but from the viewpoint of obtaining excellent sensitivity and excellent film-coating characteristics of the image recording layer, is preferably in a range of approximately 0.3 to 3.0 g/m².

### <Undercoat layer>

The planographic printing plate precursor according to the embodiment of the present disclosure preferably has an undercoat layer (also referred to as an interlayer in some cases) between the image recording layer and the support. Since intimate attachment of the support to the image recording layer is stronger in an exposed area and the support is easily peeled off from the image recording layer in an unexposed area, the undercoat layer contributes to improvement of developability without degrading printing durability. In addition, in a case of infrared laser exposure, the undercoat layer functions as a heat insulating layer so that a degradation in sensitivity due to heat, generated by the exposure, being diffused in the support is prevented.

Examples of a compound which is used for the undercoat layer include a polymer having an adsorptive group which can be adsorbed to the surface of the support and a hydrophilic group. In order to improve adhesiveness to the image recording layer, a polymer having an adsorptive group and a hydrophilic group and further having a cross-linking group is preferable. The compound which is used for the undercoat layer may be a low-molecular weight compound or a polymer. The compound which is used for the undercoat layer may be used in a mixed form of two or more kinds thereof as necessary.

In a case where the compound which is used for the undercoat layer is a polymer, a copolymer of a monomer having an adsorptive group, a monomer having a hydrophilic group, and a monomer having a cross-linking group is preferable.

As the adsorptive group which can be adsorbed to the surface of the support, a phenolic hydroxy group, a carboxy group, -PO₃H₂, -OPO₃H₂, -CONHSO₂-, -SO₂NHSO₂-, or -COCH₂COCH₃ is preferable. As the hydrophilic group, a sulfo group or a salt thereof, or a salt or a carboxy group is preferable. As the cross-linking group, an acrylic group, a methacrylic group, an acrylamide group, a methacrylamide group, an allyl group, or the like is preferable.

The polymer may have a cross-linking group introduced due to the formation of a salt between a polar substituent of the polymer and a compound having a substituent having an opposite charge of the above-described polar substituent and an ethylenically unsaturated bond, and may be further copolymerized with a monomer other than the above-described monomers, preferably a hydrophilic monomer.

Specifically, preferred examples thereof include a silane coupling agent having an ethylenic double bond reactive group which is capable of addition polymerization described in JP1998-282679A (JP-H10-282679A) and a phosphorus compound having an ethylenic double bond reactive group described in JP1990-304441A (JP-H02-304441A). A low-molecular weight or high-molecular weight compound having a cross-linking group (preferably an ethylenically unsaturated bond group), a functional group which interacts with the surface of the support, and a hydrophilic group, which is described in JP2005-238816A, JP2005-125749A, JP2006-239867A, and JP2006-215263A, is also preferably used.

More preferred examples thereof include a high-molecular weight polymer having an adsorptive group which can be adsorbed to the surface of the support, a hydrophilic group, and a cross-linking group described in JP2005-125749Aand JP2006-188038A.

The content of the ethylenically unsaturated bond group in the polymer which is used for the undercoat layer is preferably in a range of 0.1 mmol to 10.0 mmol and more preferably in a range of 0.2 mmol to 5.5 mmol per 1 g of the polymer.

The weight-average molecular weight (Mw) of the polymer which is used for the undercoat layer is preferably 5,000 or greater and more preferably in a range of 10,000 to 300,000.

In order to prevent stain over time, the undercoat layer may contain a chelating agent, a secondary or tertiary amine, a polymerization inhibitor, and a compound (for example, 1,4-diazabicyclo[2.2.2]octane (DABCO), 2,3,5,6-tetrahydroxy-p-quinone, chloranil, sulfophthalic acid, hydroxyethyl ethylene diamine triacetic acid, dihydroxyethyl ethylene diamine diacetic acid, or hydroxyethyl imino diacetic acid) which includes an amino group or a functional group having polymerization inhibiting ability and a group interacting with the surface of the support, in addition to the compounds for the undercoat layer described above.

The undercoat layer is applied according to a known method. The coating amount (solid content) of the undercoat layer is preferably in a range of 0.1 mg/m² to 100 mg/m² and more preferably in a range of 1 mg/m² to 30 mg/m².

### <Protective layer>

The planographic printing plate precursor according to the embodiment of the present disclosure preferably has a protective layer (also referred to as an overcoat layer in some cases) on the image recording layer. The protective layer has a function of suppressing an image formation-impairing reaction caused by oxygen shielding and additionally has a function of preventing the generation of scratches in the image recording layer and the ablation during exposure using high-illuminance lasers.

Protective layers having the above-described characteristics are described in, for example, the specification of US3458311A and JP1980-049729B (JP-S55-049729B). As poor oxygen-transmissible polymers which can be used for the protective layer, it is possible to appropriately select and use any one of water-soluble polymers or water-insoluble polymers, and if necessary, it is also possible to use two or more the polymers in a mixed form. Specific examples thereof include polyvinyl alcohols, modified polyvinyl alcohols, polyvinylpyrrolidone, water-soluble cellulose derivatives, and poly(meth)acrylonitrile.

As the modified polyvinyl alcohols, acid-modified polyvinyl alcohols having carboxy groups or sulfo groups are preferably used. Specific examples thereof include modified-polyvinyl alcohols described in JP2005-250216A and JP2006-259137A.

The protective layer preferably includes an inorganic layered compound in order to enhance an oxygen-shielding property. The inorganic layered compound refers to particles having thin flat plate shapes, and examples thereof include mica groups such as natural mica and synthetic mica, talc represented by a formula 3MgO·4SiO·H₂O, taeniolite, montmorillonite, saponite, hectorite, and zirconium phosphate.

Mica compound is preferably used as the inorganic layered compound. Examples of the mica compound include mica groups such as natural mica and synthetic mica represented by Formula: A(B,C)₂₋₅D₄O₁₀(OH,F,O)₂ [here, A is any one of K, Na, or Ca, B and C are any one of Fe(II), Fe(III), Mn, Al, Mg, or V, and D is Si or Al].

In the mica groups, examples of the natural mica include muscovite, paragonite, phlogopite, biotite, and lepidolite. Examples of the synthetic mica include non-swelling micas such as fluorphlogopite KMg₃(AlSi₃O₁₀)F₂ and potassium tetrasilic mica KMg_{2.5}(Si₄O₁₀)F₂, and swelling micas Na tetrasilylic mica NaMg_{2.5}(Si₄O₁₀)F₂, Na or Li taeniolite (Na,Li)Mg₂Li(Si₄O₁₀)F₂, and montmorillonite-based Na or Li hectorite (Na,Li)_{1/8}Mg_{2/5}Li_{1/8}(Si₄O₁₀)F₂. Furthermore, synthetic smectite is also useful.

Among the above-described mica compounds, fluorine-based swelling mica is particularly useful. That is, the swelling synthetic mica has a laminated structure consisting of a unit crystal lattice layer having a thickness of approximately 10 Å to 15 Å (1 Å = 0.1 nm), and the metal atom substitution in the lattice thereof is significantly larger than that of other clay minerals. As a result, positive charges are deficient in the lattice layers, and cations such as Li⁺, Na⁺, Ca²⁺, and Mg²⁺ are adsorbed between the layers in order to compensate for the deficiency. Cations interposed between the layers are referred to as exchangeable cations and are exchangeable with various cations. In particular, in a case where the cations between the layers are Li⁺ or Na⁺, the ionic radius is small, and thus the bonds between layered crystal lattices are weak, and mica is significantly swollen by water. Cleavage easily occurs in a case of application of a shear force in this state, and a stabilized sol is formed in water. The swelling synthetic mica has a strong above-described tendency, and is particularly preferably used.

From the viewpoint of diffusion control, regarding the shapes of the mica compounds, the thickness is preferably thin, and the planar size is preferably large as long as the smoothness and active light ray-transmitting properties of coating surfaces are not impaired. Therefore, the aspect ratio is preferably 20 or higher, more preferably 100 or higher, and particularly preferably 200 or higher. The aspect ratio is the ratio of the long diameter to the thickness of a particle and can be measured from projection views obtained from the microphotograph of the particles. As the aspect ratio increases, the obtained effect is stronger. The upper limit value of the aspect ratio is not limited, and may be, for example, 1000 or less.

Regarding the particle diameters of the mica compound, the average long diameter thereof is preferably in a range of 0.3 µm to 20 µm, more preferably in a range of 0.5 µm to 10 µm, and particularly preferably in a range of 1 µm to 5 µm. The average thickness of the particles is preferably 0.1 µm or smaller, more preferably 0.05 µm or smaller, and particularly preferably 0.01 µm or smaller. Specifically, for example, in the case of the swelling synthetic mica which is a typical compound, a preferred aspect has a thickness of approximately 1 nm to 50 nm and a surface size (long diameter) of approximately 1 µm to 20 µm.

The content of the inorganic layered compound is preferably in a range of 1% by mass to 60% by mass and more preferably in a range of 3% by mass to 50% by mass with respect to the total solid content of the protective layer. Even in a case where a plurality of types of inorganic layered compounds are used in combination, the total amount of the inorganic layered compounds is preferably the above-described content. In a case where the total amount is within the above-described range, oxygen-shielding property improves and excellent sensitivity can be obtained. In addition, the degradation of impressing property can be prevented.

The protective layer may contain known additives such as a plasticizer for imparting flexibility, a surfactant for improving coating property, and inorganic particles for controlling sliding property on the surface. In addition, the oil sensitizing agent described in the section of the image recording layer may be contained in the protective layer.

The protective layer is applied according to a known method. The coating amount (solid content) of the protective layer is preferably in a range of 0.01 g/m² to 10 g/m², more preferably in a range of 0.02 g/m² to 3 g/m², and particularly preferably in a range of 0.02 g/m² to 1 g/m².

### (Method of producing planographic printing plate)

A planographic printing plate can be produced by performing a development treatment by image-exposing the planographic printing plate precursor according to the embodiment of the present disclosure.

The method of producing a planographic printing plate according to the embodiment of the present disclosure preferably includes a step (hereinafter, also referred to as an "exposure step") of image-wise exposing the planographic printing plate precursor according to the embodiment of the present disclosure to form an exposed area and an unexposed area, and a step (hereinafter, also referred to as an "on-press development step") of supplying at least one of printing ink or dampening water to remove the unexposed area.

In addition, another embodiment of the method of producing a planographic printing plate according to the embodiment of the present disclosure preferably includes, in this order, an exposure step of image-wise exposing the planographic printing plate precursor according to the embodiment of the present disclosure to form an exposed area and an unexposed area, and a step (hereinafter, also referred to as a "development step") of supplying a developer having a pH of 2 or higher and 11 or lower to remove the unexposed area.

Hereinafter, regarding the method of producing a planographic printing plate according to the embodiment of the present disclosure and a planographic printing method according to the present disclosure, preferred aspects of the respective steps will be sequentially described. The planographic printing plate precursor according to the embodiment of the present disclosure can also be developed using a developer.

### <Exposure step>

The method of producing a planographic printing plate according to the embodiment of the present disclosure preferably includes an exposure step of image-wise exposing the planographic printing plate precursor according to the embodiment of the present disclosure to form an exposed area and an unexposed area. It is preferable that the planographic printing plate precursor according to the embodiment of the present disclosure is exposed with laser through a transparent original image having a line image, a halftone image, or the like, or image-wise exposed by laser beam scanning according to digital data.

The wavelength of a light source is preferably in a range of 750 nm to 1,400 nm. As the light source having a wavelength of 750 nm to 1,400 nm, a solid-state laser or a semiconductor laser that radiates infrared rays is suitable. The output of the infrared laser is preferably 100 mW or greater, the exposure time per one pixel is preferably within 20 microseconds, and the irradiation energy quantity is preferably in a range of 10 mJ/cm² to 300 mJ/cm². In addition, for the purpose of reducing the exposure time, it is preferable to use a multi-beam laser device. The exposure mechanism may be any one of an internal drum system, an external drum system, a flat bed system, or the like.

The image exposure can be performed using a plate setter according to a usual method. In the case of on-press development, image exposure may be performed on a printing press after the planographic printing plate precursor is mounted in the printing press.

### <On-press development step>

The method of producing a planographic printing plate according to the embodiment of the present disclosure preferably includes an on-press development step of supplying at least one of printing ink or dampening water to remove the unexposed area.

In addition, the method of producing a planographic printing plate according to the embodiment of the present disclosure may be performed using a developing method using a developer (developer treatment method).

Hereinafter, the on-press development method will be described.

### [On-press development method]

In the on-press development method, a planographic printing plate is preferably produced by supplying oily ink and an aqueous component to the image-exposed planographic printing plate precursor on a printing press to remove the image recording layer in a non-image area.

That is, in a case where the planographic printing plate precursor is image-exposed and then mounted as it is in a printing press without performing any development treatment thereon, or in a case where the planographic printing plate precursor is mounted in a printing press, image-exposed on the printing press, and subsequently supplied with oily ink and an aqueous component to perform printing, in the early stage of printing, the non-cured image recording layer in the non-image area is dissolved or dispersed and thus removed by any one or both of the supplied oily ink and aqueous component, and a hydrophilic surface is exposed in the removed portion. On the other hand, in the exposed area, the image recording layer cured by exposure forms an oily ink receiving unit having a lipophilic surface. Any of the oily ink or the aqueous component may be supplied to the plate surface first, but from the viewpoint of preventing the aqueous component from being polluted by a component of the image recording layer to be removed, the oily ink is preferably supplied first. In the above-described manner, the planographic printing plate precursor is on-press-developed on the printing press and used as it is for printing a large number of sheets. As the oily ink and the aqueous component, typical printing ink and dampening water for planographic printing are suitably used.

In the laser for image-exposing the planographic printing plate precursor according to the embodiment of the present disclosure, the wavelength of the light source is preferably in a range of 300 nm to 450 nm or in a range of 750 nm to 1,400 nm. In a case of a light source of 300 nm to 450 nm, a planographic printing plate precursor containing a sensitizing dye in the image recording layer, which has the maximum absorption in this wavelength range is preferably used, and as a light source of 750 to 1,400 nm, those described above are preferably used. As the light source of 300 nm to 450 nm, a semiconductor laser is suitable.

### [Developer treatment method]

A planographic printing plate can be produced from the planographic printing plate precursor according to the embodiment of the present disclosure through a development treatment using a developer by appropriately selecting the polymer A, the binder polymer, or the like, which is a constituent component of the image recording layer. The development treatment using a developer includes an aspect (also referred to as a simple development treatment) using a developer which may contain at least one compound selected from the group consisting of a surfactant and a water-soluble polymer compound and having a pH of approximately 2 to 11.

It is also possible to perform development and a gum solution treatment step at the same time by a method adding a water-soluble polymer compound to the developer as necessary, and the like.

Therefore, the post-water washing step is not particularly required, and it is also possible to perform development and the gum solution treatment step by a single one-solution step and then perform a drying step. Thus, as the development treatment using a developer, a method of producing a planographic printing plate including a step of subjecting an image-exposed planographic printing plate precursor to a development treatment using a developer having a pH of 2 to 11 is preferable. After the development treatment, it is preferable to remove the excess developer using a squeeze roller and then perform drying.

That is, in the development step of the method of producing a planographic printing plate according to the embodiment of the present disclosure, it is preferable to perform the development treatment and the gum solution treatment by a single one-solution step.

Development and the gum solution treatment being performed by a single one-solution step means that the development treatment and the gum solution treatment are not performed as separate steps, and the development treatment and the gum solution treatment are performed in a single step using one solution.

The development treatment can be suitably performed using an automatic development treatment machine including unit for supplying the developer and a rubbing member. An automatic development treatment machine in which a rotary brush roll is used as the rubbing member is particularly preferable.

The number of the rotary brush rolls is preferably two or more. Furthermore, the automatic development treatment machine preferably includes, after development treatment unit, unit for removing the excess developer such as a squeeze roller or drying unit such as a hot-air device. In addition, the automatic development treatment machine may include, before the development treatment unit, preheating unit for performing a heating treatment on the planographic printing plate precursor after image exposure.

A treatment in such an automatic development treatment machine has an advantage of being released from a need for dealing with development scum derived from the image recording layer (and in a case where the planographic printing plate precursor has a protective layer, the protective layer), which is generated in the case of so-called on-press development treatment.

In the development step, in the case of a manual treatment, as a development treatment method, for example, a method in which sponge, absorbent cotton, or the like is soaked with an aqueous solution, the entire plate surface is treated while being rubbed and dried after the end of the treatment is suitably exemplified. In the case of an immersion treatment, for example, a method in which the planographic printing plate precursor is immersed and stirred for 60 seconds in a vat, deep tank, or the like containing an aqueous solution and then dried while being rubbed with absorbent cotton, sponge, or the like is suitably exemplified.

In the development treatment, a device having a simplified structure and simplified steps is preferably used.

For example, in an alkali development treatment, the protective layer is removed by the pre-water washing step, next, development is performed using an alkaline developer having high pH, after that, alkali is removed in the post-water washing step, a gum treatment is performed in a gum pulling step, and drying is performed in the drying step. In the simple development treatment, development and gum pulling can be performed at the same time using one solution. Therefore, it is possible to omit the post-water washing step and the gum treatment step, and it is preferable to perform the drying step as necessary after development and gum pulling (gum solution treatment) are performed using one solution.

Furthermore, it is preferable to perform the removal of the protective layer, development, and gum pulling at the same time using one solution without performing the pre-water washing step. In addition, it is preferable to remove the excess developer using a squeeze roller after development and gum pulling, and then perform drying.

In the development step, a method of immersing the planographic printing plate precursor in the developer once may be used, or a method of immersing the planographic printing plate precursor in the developer twice or more may be used. Among these, a method of immersing the planographic printing plate precursor in the developer once or twice is preferable.

In the immersion, the exposed planographic printing plate precursor may be put into a developer tank in which the developer is stored or the developer is blown onto the plate surface of the exposed planographic printing plate precursor from a spray or the like.

Even in a case of immersing the planographic printing plate precursor in the developer twice or more, a case where the planographic printing plate precursor is immersed in the same developer or the developer and a developer (fatigued solution) in which the components of the image recording layer are dissolved or dispersed by the development treatment twice or more is referred to as the development treatment using one solution (one-solution treatment).

In the development treatment, a rubbing member is preferably used, and a rubbing member such as a brush is preferably installed in a development bath for removing the non-image area of the image recording layer.

The development treatment can be performed according to a usual method at a temperature of preferably at 0°C to 60°C and more preferably 15°C to 40°C by, for example, immersing the exposed planographic printing plate precursor in the developer and rubbing the planographic printing plate precursor with a brush or drawing a treatment liquid prepared in an external tank using a pump, blowing the developer from a spray nozzle, and rubbing the planographic printing plate precursor with the brush. The development treatment can be continuously performed a plurality of times. For example, the development treatment can be performed by drawing the developer prepared in an external tank using a pump, blowing the developer from a spray nozzle, rubbing the planographic printing plate precursor with the brush, then, again, blowing the developer from the spray nozzle, and rubbing the planographic printing plate precursor with the brush. In the case of performing the development treatment using an automatic developing machine, the developer is fatigued as the treatment amount increases, and thus it is preferable to restore the treatment capability by using a supplementary solution or a fresh developer.

In the development treatment, a gum coater or an automatic developing machine known for the use for a presensitized plate (PS plate) or a computer to plate (CTP) in the related art can also be used. In the case of using the automatic developing machine, it is possible to apply any method of, for example, a method of treating the planographic printing plate precursor by drawing a developer prepared in a developer tank or a developer prepared in an external tank using a pump and blowing the developer from a spray nozzle, a method of treating the planographic printing plate precursor by immersing and transporting the printing plate in a tank filled with a developer using a guide roll in the developer or the like, or a so-called single-use treatment method of treating the planographic printing plate precursor by supplying only a necessary amount of a substantially unused developer to each plate. In any method, it is more preferable to use a rubbing mechanism such as a brush, molleton, or the like. For example, commercially available automatic developing machines (for example, Clean Out Unit C85/C125, Clean-Out Unit+ C85/120, FCF 85V, FCF 125V, FCF News (manufactured by Glunz & Jensen), Azura CX85, Azura CX125, and Azura CX150 (manufactured by AGFA Graphics N.V)) can be used. In addition, it is also possible to use a device into which a laser exposure unit and an automatic developing machine unit are integrally combined.

The details of components and the like of the developer used in the development step will be described below.

### -pH-

The pH of the developer is preferably in a range of 2 to 11, more preferably in a range of 5 to 9, and still more preferably in a range of 7 to 9. From the viewpoint of developability and dispersibility of the image recording layer, it is advantageous to the value of the pH to be high; however, regarding printability, particularly, stain suppression, it is advantageous to set the value of the pH to be low.

Here, the pH is a value measured at 25°C using a pH meter (model No.: HM-31, manufactured by DKK-TOA Corporation).

### -Surfactant-

The developer can contain a surfactant such as an anionic surfactant, a non-ionic surfactant, a cationic surfactant, and an amphoteric surfactant.

From the viewpoint of brush stain property, the developer preferably contains at least one selected from the group consisting of an anionic surfactant and an amphoteric surfactant.

In addition, the developer preferably contains a non-ionic surfactant and more preferably contains a non-ionic surfactant and at least one selected from the group consisting of an anionic surfactant and an amphoteric surfactant.

Preferred examples of the anionic surfactant include a compound represented by the Formula (I).

R¹-Y¹-X¹ (I)

In Formula (I), R¹ represents an alkyl group, a cycloalkyl group, an alkenyl group, an aralkyl group, or an aryl group, which may have a substituent.

As the alkyl group, for example, an alkyl group having 1 to 20 carbon atoms is preferable, and preferred specific examples thereof include a methyl group, an ethyl group, a propyl group, an n-butyl group, a sec-butyl group, a hexyl group, a 2-ethylhexyl group, an octyl group, a decyl group, a dodecyl group, a hexadecyl group, and a stearyl group.

The cycloalkyl group may be monocyclic or polycyclic. As the monocyclic cycloalkyl group, a monocyclic cycloalkyl group having 3 to 8 carbon atoms is preferable, and a cyclopropyl group, a cyclopentyl group, a cyclohexyl group, or a cyclooctyl group is more preferable. Preferred examples of the polycyclic cycloalkyl group include an adamantyl group, a norbornyl group, an isobornyl group, a camphanyl group, a dicyclopentyl group, an α-pinel group, and a tricyclodecanyl group.

As the alkenyl group, for example, an alkenyl group having 2 to 20 carbon atoms is preferable, and preferred specific examples thereof include a vinyl group, an allyl group, a butenyl group, and a cyclohexenyl group.

As the aralkyl group, for example, an aralkyl group having 7 to 12 carbon atoms is preferable, and preferred specific examples thereof include a benzyl group, a phenethyl group, and a naphthylmethyl group.

As the aryl group, for example, an aryl group having 6 to 15 carbon atoms is preferable, and preferred specific examples thereof include a phenyl group, a tolyl group, a dimethylphenyl group, a 2,4,6-trimethylphenyl group, a naphthyl group, an anthryl group, and a 9,10-dimethoxyanthryl group.

As the substituent, a monovalent nonmetallic atomic group excluding a hydrogen atom is used, and preferred examples thereof include a halogen atom (F, Cl, Br, or I), a hydroxy group, an alkoxy group, an aryloxy group, an acyl group, an amide group, an ester group, an acyloxy group, a carboxy group, a carboxylic acid anion group, and a sulfonic acid anion group.

As specific examples of the alkoxy group in the substituent, a methoxy group, an ethoxy group, a propyloxy group, an isopropyloxy group, a butyloxy group, a pentyloxy group, a hexyloxy group, a dodecyloxy group, a stearyloxy group, a methoxyethoxy group, a poly(ethyleneoxy) group, and a poly(propyleneoxy) group, which respectively have 1 to 40 carbon atoms, are preferable; and these groups respectively having 1 to 20 carbon atoms are more preferable. Examples of the aryloxy group include a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, and a naphthyloxy group, respectively having 6 to 18 carbon atoms. Examples of the acyl group include an acetyl group, a propanoyl group, a butanoyl group, a benzoyl group, and a naphthoyl group, respectively having 2 to 24 carbon atoms. Examples of the amide group include an acetamide group, a propionic acid amide group, a dodecanoic acid amide group, a palmitic acid amide group, a stearic acid amide group, a benzoic acid amide group, and a naphthoic acid amide group, respectively having 2 to 24 carbon atoms. Examples of the acyloxy group include an acetoxy group, a propanoyloxy group, a benzoyloxy group, and a naphthoyloxy group, respectively having 2 to 20 carbon atoms. Examples of the ester group include a methyl ester group, an ethyl ester group, a propyl ester group, a hexyl ester group, an octyl ester group, a dodecyl ester group, and a stearyl ester group, respectively having 1 to 24 carbon atoms. The substituent may be formed by consisting of a combination of two or more substituents described above.

X¹ represents a sulfonate group, a sulfate monoester group, a carboxylate group, or a phosphate group.

Y¹ represents a single bond, -CₙH₂ₙ-, -Cₙ₋ₘH₂₍ₙ₋ₘ₎OCₘH₂ₘ-, -O-(CH₂CH₂O)ₙ-, -O-(CH₂CH₂CH₂O)ₙ-, -CO-NH-, or a divalent linking group formed by consisting of a combination of two or more of these, in which the expressions of "n≥1" and "n≥m≥0" is satisfied.

Among examples of the compound represented by Formula (I), from the viewpoint of scratch and stain resistance, a compound represented by Formula (I-A) or Formula (I-B) is preferable.

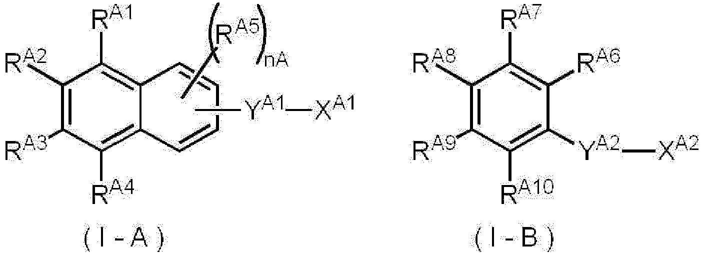

In Formulae (I-A) and (I-B), R^{A1} to R^{A10} each independently represent a hydrogen atom or an alkyl group, nA represents an integer of 1 to 3, X^{A1} and X^{A2} each independently represent a sulfonate group, a sulfate monoester group, a carboxylate group, or a phosphate group, and Y^{A1} and Y^{A2} each independently represent a single bond, -CₙH₂ₙ-, -Cₙ₋ₘH₂₍ₙ₋ₘ₎OCₘH₂ₘ-, -O-(CH₂CH₂O)ₙ-, -O-(CH₂CH₂CH₂O)ₙ-, -CO-NH-, or a divalent linking group formed by combining two or more of these, in which the expressions of "n≥1" and "n≥m≥0" is satisfied. The sum total number of carbon atoms in R^{A1} to R^{A5} or R^{A6} to R^{A10}, and Y^{A1} or Y^{A2} is 3 or greater.

The total number of carbon atoms in R^{A1} to R^{A5} and Y^{A1}, or R^{A6} to R^{A10} and Y^{A2} in the compound represented by Formula (I-A) or Formula (I-B) is preferably 25 or less and more preferably in a range of 4 to 20. The structure of the above-described alkyl group may be linear or branched.

It is preferable that X^{A1} and X^{A2} in the compound represented by Formula (I-A) or Formula (I-B) represent a sulfonate group or a carboxylate group. In addition, the salt structure in X^{A1} and X^{A2} is preferable, from the viewpoint that the solubility of the alkali metal salt in a water-based solvent is particularly excellent. Among the salt structures, a sodium salt or a potassium salt is particularly preferable.

As the compound represented by Formula (I-A) or Formula (I-B), the description in paragraphs 0019 to 0037 of JP2007-206348A can be referred to.

As the anionic surfactant, the compounds described in paragraphs 0023 to 0028 of JP2006-065321A can be suitably used.

The amphoteric surfactant used for the developer is not particularly limited, and examples thereof include an amine oxide-based surfactant such as alkyl dimethylamine oxide; a betaine-based surfactant such as alkyl betaine, fatty acid amide propyl betaine, or alkyl imidazole; and an amino acid-based surfactant such as sodium alkylamino fatty acid.

In particular, alkyl dimethylamine oxide which may have a substituent, alkyl carboxy betaine which may have a substituent, or alkyl sulfobetaine which may have a substituent is preferably used. Specific examples thereof include compounds represented by Formula (2) in paragraph 0256 of JP2008-203359A, compounds represented by Formulae (I), Formula (II), and Formula (VI) in paragraph 0028 of JP2008-276166A, and compounds described in paragraphs 0022 to 0029 of JP2009-047927A.

As an amphoteric surfactant used for the developer, a compound represented by formula (1) or a compound represented by Formula (2) is preferable.

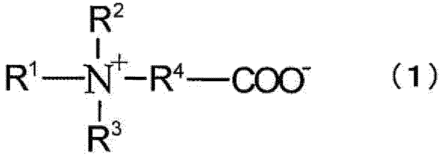

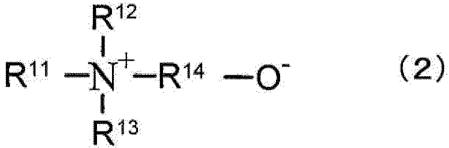

In Formulae (1) and (2), R¹ and R¹¹ each independently represent an alkyl group having 8 to 20 carbon atoms or an alkyl group having a linking group, which has 8 to 20 carbon atoms in total.

R², R³, R¹², and R¹³ each independently represent a hydrogen atom, an alkyl group, or a group containing an ethylene oxide structure.

R⁴ and R¹⁴ each independently represent a single bond or an alkylene group.

In addition, two groups among R¹, R², R³, and R⁴ may be bonded to each other to form a ring structure, and two groups among R¹¹, R¹², R¹³, and R¹⁴ may be bonded to each other to form a ring structure.

In the compound represented by Formula (1) or the compound represented by Formula (2), the hydrophobic portion is bigger as the total number of carbon atoms increases, and the solubility in a water-based developer is decreased. In this case, the solubility is improved by mixing an organic solvent such as alcohol that assists dissolution with water as a dissolution assistant, but the surfactant cannot be dissolved within a proper mixing range in a case where the total number of carbon atoms is extremely large. Accordingly, the sum total number of carbon atoms of R¹ to R⁴ or R¹¹ to R¹⁴ is preferably in a range of 10 to 40 and more preferably in a range of 12 to 30.

The alkyl group having a linking group represented by R¹ or R¹¹ has a structure in which a linking group is present between alkyl groups. In other words, in a case where one linking group is present, the structure can be represented by "-alkylene group-linking group-alkyl group". Examples of the linking group include an ester bond, a carbonyl bond, and an amide bond. The structure may have two or more linking groups, but it is preferable that the structure has one linking group, and an amide bond is particularly preferable. The total number of carbon atoms of the alkylene group bonded to the linking group is preferably in a range of 1 to 5. The alkylene group may be linear or branched, but a linear alkylene group is preferable. The number of carbon atoms of the alkyl group bonded to the linking group is preferably in a range of 3 to 19, and the alkyl group may be linear or branched, but a linear alkyl is preferable.

In a case where R² or R¹² represents an alkyl group, the number of carbon atoms thereof is preferably in a range of 1 to 5 and particularly preferably in a range of 1 to 3. The alkyl group may be linear or branched, but a linear alkyl group is preferable.

In a case where R³ or R¹³ represents an alkyl group, the number of carbon atoms thereof is preferably in a range of 1 to 5 and particularly preferably in a range of 1 to 3. The alkyl group may be linear or branched, but a linear alkyl group is preferable.

Examples of the group containing an ethylene oxide structure, which is represented by R³ or R¹³, include a group represented by -R^{a}(CH₂CH₂O)ₙR^{b}. Here, R^{a} represents a single bond, an oxygen atom, or a divalent organic group (preferably having 10 or less carbon atoms), R^{b} represents a hydrogen atom or an organic group (preferably having 10 or less carbon atoms), and n represents an integer of 1 to 10.

In a case where R⁴ and R¹⁴ represents an alkylene group, the number of carbon atoms thereof is preferably in a range of 1 to 5 and particularly preferably in a range of 1 to 3. The alkylene group may be linear or branched, but a linear alkylene group is preferable.

The compound represented by Formula (1) or the compound represented by Formula (2) preferably has an amide bond and more preferably has an amide bond as a linking group of R¹ or R¹¹.

Representative examples of the compound represented by Formula (1) or the compound represented by Formula (2) are as follows, but the present disclosure is not limited thereto.

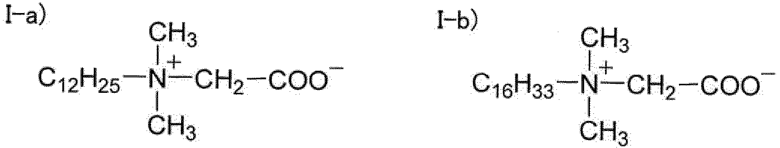

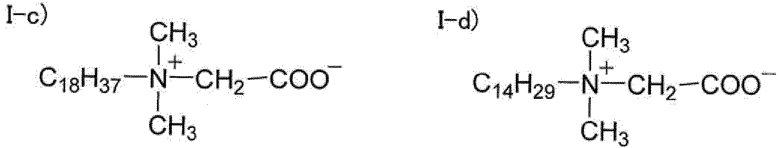

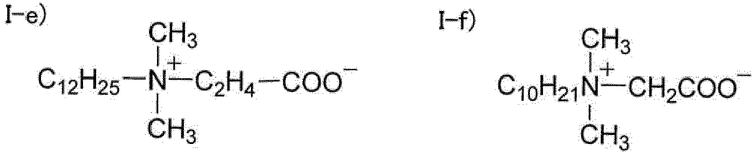

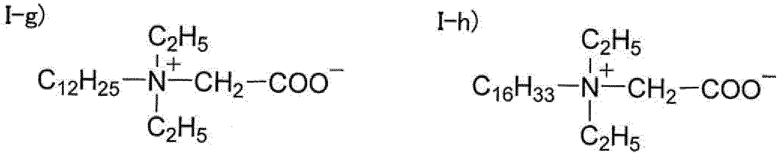

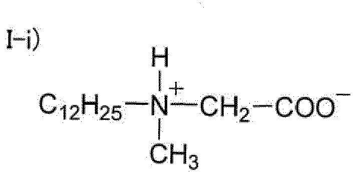

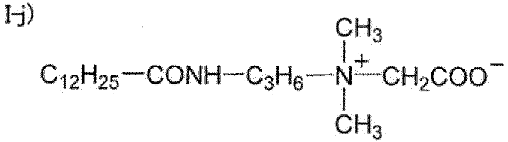

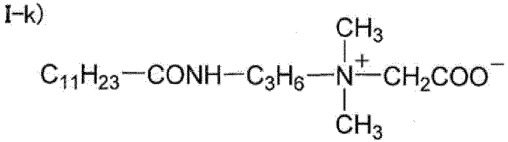

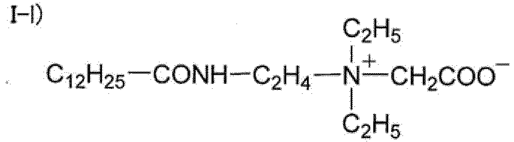

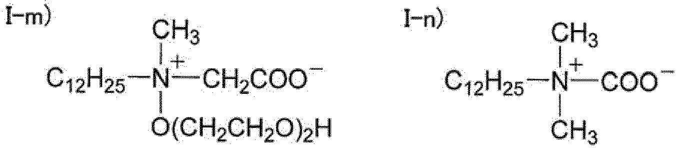

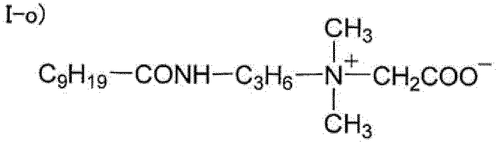

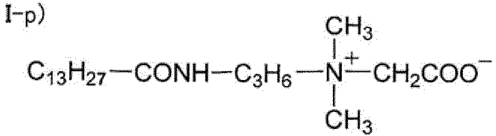

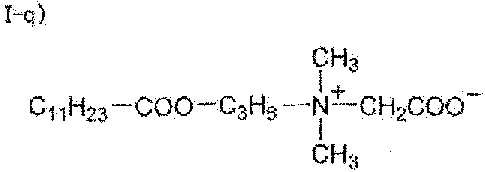

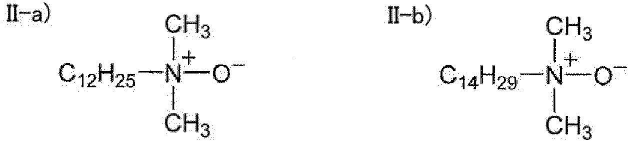

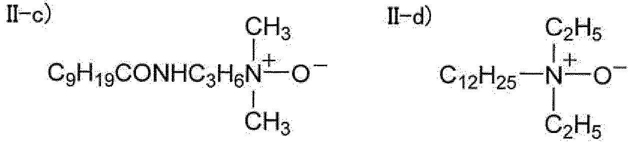

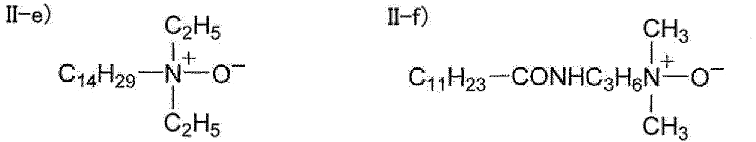

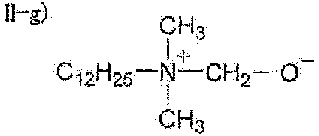

The compound represented by Formula (1) or Formula (2) can be synthesized according to a known method. In addition, commercially available products may be used. Examples of the commercially available products of the compound represented by Formula (1) include SOFRAZOLINE LPB, SOFTAZOLINE LPB-R, and VISTA MAP (manufactured by Kawaken Fine Chemicals Co., Ltd.), and TAKESAAF C-157L (manufactured by TAKEMOTO OIL & FAT Co., Ltd.). Examples of the commercially available products of the compound represented by Formula (2) include SOFTAZOLINE LAO (manufactured by Kawaken Fine Chemicals Co., Ltd.) and AMOGEN AOL (manufactured by DKS Co., Ltd.).

The amphoteric surfactant may be used alone or in combination of two or more kinds thereof in a developer.

Examples of non-ionic surfactant include polyoxyethylene alkyl ethers, polyoxyethylene alkyl phenyl ethers, polyoxyethylene polystyryl phenyl ether, glycerin fatty acid partial esters, sorbitan fatty acid partial esters, pentaerythritol fatty acid partial esters, propylene glycol monofatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, polyoxyethylene diglycerins, fatty acid diethanolamides, N,N-bis-2-hydroxyalkylamines, polyoxyethylene alkylamine, triethanolamine fatty acid ester, trialkylamine oxide, polyoxyethylene alkyl phenyl ethers, and polyoxyethylene-polyoxypropylene block copolymers.

In addition, acetylene glycol-based and acetylene alcohol-based oxyethylene adducts, and fluorine-based surfactants can also be used. These surfactants can be used in combination of two or more kinds thereof.

Particularly preferred examples of the non-ionic surfactant include a non-ionic aromatic ether-based surfactant represented by Formula (N1).

X^{N}-Y^{N}-O-(A¹)_{nB}-(A²)_{mB}-H (N1)

In the formula, X^{N} represents an aromatic group which may have a substituent, Y^{N} represents a single bond or an alkylene group having 1 to 10 carbon atoms, A¹ and A² are different groups and represent any of -CH₂CH₂O- or -CH₂CH(CH₃)O-, and nB and mB each independently represent an integer of 0 to 100, provided that both of nB and mB is not 0 at the same time, and both of nB and mB is not 1 in a case where any one of nB or mB is 0.

In the formula, examples of the aromatic group of X^{N} include a phenyl group, a naphthyl group, and an anthranyl group. These aromatic groups may have a substituent. Examples of the substituent include an organic group having 1 to 100 carbon atoms. In the formula, the compound may be a random or block copolymer in a case where both A¹ and A² are present.

Specific examples of the organic group having 1 to 100 carbon atoms include aliphatic hydrocarbon groups or aromatic hydrocarbon groups, which may be saturated or unsaturated and may be linear or branched, such as an alkyl group, an alkenyl group, an alkynyl group, an aryl group, an aralkyl group, an alkoxy group, an aryloxy group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an acylamino group, an N-alkylacylamino group, an N-arylacylamino group, an acyl group, an alkoxycarbonylamino group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, a polyoxyalkylene chain, and the above-described organic group to which a polyoxyalkylene chain is bonded. The alkyl group may be linear or branched.

In addition, as the non-ionic surfactant, compounds described in paragraphs 0030 to 0040 of JP2006-065321A can also be suitably used.

The cationic surfactant is not particularly limited, and known surfactants of the related art can be used. Examples thereof include alkylamine salts, quaternary ammonium salts, alkylimidazolinium salts, polyoxyethylene alkylamine salts, and polyethylene polyamine derivatives.

The surfactant may be used alone or in combination of two or more kinds thereof.

The content of the surfactant is preferably in a range of 1% by mass to 25% by mass, more preferably in a range of 2% by mass to 20% by mass, still more preferably in a range of 3% by mass to 15% by mass, and particularly preferably in a range of 5% by mass to 10% by mass with respect to the total mass of the developer. In a case where the content thereof is in the above-described range, scratch and stain resistance is excellent, the dispersibility of the development scum is excellent, and the inking property of a planographic printing plate to be obtained is excellent.

### -Water-soluble polymer compound-

The developer is capable of containing a water-soluble polymer compound from the viewpoint of the viscosity adjustment of the developer and the protection of the plate surface of a planographic printing plate to be obtained.

Examples of the water-soluble polymer compound include a water-soluble polymer compound such as soybean polysaccharides, modified starch, gum arabic, dextrin, a fiber derivative (such as carboxymethyl cellulose, carboxyethyl cellulose, or methyl cellulose) and a modified product thereof, pullulan, polyvinyl alcohol and a derivative thereof, a copolymer of polyvinylpyrrolidone, polyacrylamide and acrylamide, a vinyl methyl ether/maleic anhydride copolymer, a vinyl acetate/maleic anhydride copolymer, and a styrene/maleic anhydride copolymer.

As the soybean polysaccharides, soybean polysaccharides which have been known in the related art can be used. For example, SOYAFIBE (trade name, manufactured by FUJI OIL, CO., LTD.) can be used as a commercially available product, and various grades of products can be used. Preferred examples thereof include products in which the viscosity of a 10% by mass aqueous solution is in a range of 10 mPa·s to 100 mPa s.

As the modified starch, starch represented by Formula (III) is preferable. Any of starch such as corn, potato, tapioca, rice, or wheat can be used as the starch represented by Formula (III). The modification of the starch can be performed according to a method of decomposing the starch with an acid or an enzyme to have 5 to 30 glucose residues per one molecule and adding oxypropylene thereto in an alkali.

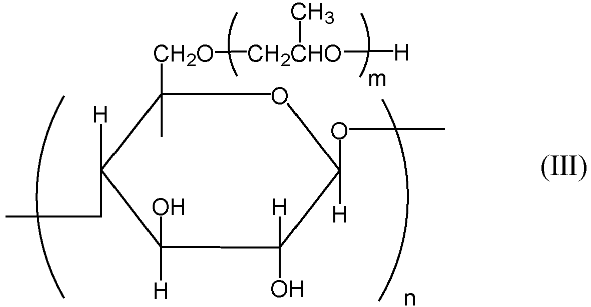

In the formula, the etherification degree (degree of substitution) is in a range of 0.05 to 1.2 per glucose unit, n represents an integer of 3 to 30, and m represents an integer of 1 to 3.

Among the examples of the water-soluble polymer compound, soybean polysaccharides, modified starch, gum arabic, dextrin, carboxymethyl cellulose, and polyvinyl alcohol are particularly preferable.

The water-soluble polymer compound can be used in combination of two or more kinds thereof.

In a case where the developer includes a water-soluble polymer compound, the content of the water-soluble polymer compound is preferably 3% by mass or less and more preferably 1% by mass or less with respect to the total mass of the developer. In the case of the above-described aspect, the viscosity of the developer is appropriate, and it is possible to suppress the development scum or the like being deposited on a roller member of the automatic developing machine.

### -Other additives-

The developer used in the present disclosure may contain a wetting agent, a preservative, a chelate compound, an antifoaming agent, an organic acid, an organic solvent, an inorganic acid, and an inorganic salt in addition to those described above.

Suitable examples of the wetting agent include ethylene glycol, propylene glycol, triethylene glycol, butylene glycol, hexylene glycol, diethylene glycol, dipropylene glycol, glycerin, trimethylolpropane, and diglycerin. The wetting agent may be used alone or in combination of two or more kinds thereof. The content of the wetting agent is preferably in a range of 0.1% by mass to 5% by mass with respect to the total mass of the developer.

As the preservative, phenol or a derivative thereof, formalin, an imidazole derivative, sodium dehydroacetate, a 4-isothiazolin-3-one derivative, benzoisothiazolin-3-one, 2-methyl-4-isothiazolin-3-one, a benzotriazole derivative, an amidine guanidine derivative, quaternary ammonium salts, derivatives of pyridine, quinoline, and guanidine, diazine, a triazole derivative, oxazole, an oxazine derivative, nitrobromoalcohol such as 2-bromo-2-nitropropane-1,3-diol, 1,1-dibromo -1-nitro-2-ethanol, and 1,1-dibromo-1-nitro-2-propanol, and the like can be preferably used.

The addition amount of the preservative is an amount of stably exhibiting the efficacy for bacteria, molds, yeasts, or the like, and is preferably in a range of 0.01% by mass to 4% by mass with respect to the total mass of the developer, even though the amount thereof varies depending on the types of bacteria, molds, and the yeasts. In addition, two or more preservatives are preferably used in combination so that there is efficacy for a variety of molds and bacteria.

Examples of the chelate compound include ethylenediaminetetraacetic acid, a potassium salt thereof, and a sodium salt thereof; diethylenetriaminepentaacetic acid, a potassium salt thereof, and a sodium salt thereof; triethylenetetraminehexaacetic acid, a potassium salt thereof, a sodium salt thereof; hydroxyethylethylenediaminetriacetic acid, a potassium salt thereof, and a sodium salt thereof; nitrilotriacetic acid and a sodium salt thereof; 1-hydroxyethane-1,1-diphosphonic acid, a potassium salt thereof, and a sodium salt thereof; and organic phosphonic acids such as amino tri(methylenephosphonic acid), a potassium salt thereof, and sodium salt thereof. Instead of the sodium salt and the potassium salt of the chelating agent, a salt of an organic amine is also effective.

The chelating agent is preferably a chelating agent which is stably present in a treatment liquid composition and does not impair printability. The content of the chelating agent is preferably in a range of 0.001% by mass to 1.0% by mass with respect to the total mass of the developer.

As the antifoaming agent, it is possible to use a typical silicone-based self-emulsification type, emulsification type, or non-ionic compound having a hydrophilic-lipophilic balance (HLB) of 5 or lower or the like. A silicone antifoaming agent is preferable.

A silicone-based surfactant is regarded as the antifoaming agent.

The content of the antifoaming agent is suitably in a range of 0.001% by mass to 1.0% by mass with respect to the total mass of the developer.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, and organic phosphonic acid. The organic acid can be used in the form of an alkali metal salt or ammonium salt thereof. The content of the organic acid is preferably in a range of 0.01% by mass to 0.5% by mass with respect to the total mass of the developer.

Examples of the organic solvent include aliphatic hydrocarbons (hexane, heptane, "ISOPAR E, H, G" (manufactured by Exxon Mobil Corporation), and the like), aromatic hydrocarbons (toluene, xylene, and the like), halogenated hydrocarbon (methylene dichloride, ethylene dichloride, trichlene, monochlorobenzene, and the like), and polar solvents.

Examples of the polar solvent include alcohols (such as methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, and methyl amyl alcohol), ketones (such as acetone, methyl ethyl ketone, ethyl butyl ketone, methyl isobutyl ketone, and cyclohexanone), esters (such as ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, and butyl levulinate), and others (such as triethyl phosphate, tricresyl phosphate, N-phenylethanolamine, and N-phenyldiethanolamine).

In a case where the organic solvent is insoluble in water, the organic solvent can be used by being solubilized in water using a surfactant or the like. In a case where the developer contains an organic solvent, from the viewpoints of safety and inflammability, the concentration of the solvent in the developer is preferably less than 40% by mass.

Examples of the inorganic acid and inorganic salt include phosphoric acid, metaphosphoric acid, primary ammonium phosphate, secondary ammonium phosphate, primary sodium phosphate, secondary sodium phosphate, primary potassium phosphate, secondary potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, and nickel sulfate. The content of the inorganic salt is preferably in a range of 0.01% by mass to 0.5% by mass with respect to the total mass of the developer.

The developer is prepared by dissolving or dispersing each of the above-described components in water as necessary. The concentration of solid contents of the developer is preferably in a range of 2% by mass to 25% by mass. The developer can be used by preparing a concentrated solution and diluting the concentrate with water before use.

The developer is preferably an aqueous developer.

From the viewpoint of the dispersibility of the development scum, the developer preferably contains an alcohol compound.

Examples of the alcohol compound include methanol, ethanol, propanol, isopropanol, and benzyl alcohol. Among these, benzyl alcohol is preferable.

From the viewpoint of dispersibility of the development scum, the content of the alcohol compound is preferably in a range of 0.01% by mass to 5% by mass, more preferably in a range of 0.1% by mass to 2% by mass, and particularly preferably in a range of 0.2% by mass to 1% by mass with respect to the total mass of the developer.

### (Planographic printing method)

### <Printing step>

The planographic printing method in the present disclosure includes a printing step of supplying a printing ink to the planographic printing plate to print a recording medium.

The printing ink is not particularly limited, and various known inks can be used as desired. In addition, as the printing ink, an oily ink or an ultraviolet curable ink (UV ink) is preferable and a UV ink is more preferable.

In addition, in the printing step, dampening water may be supplied as necessary.

In addition, the printing step may be successively performed after the on-press development step without stopping the printing press.

The recording medium is not particularly limited, and a known recording medium can be used as desired.

In the method of producing a planographic printing plate from the planographic printing plate precursor according to the embodiment of the present disclosure and the planographic printing method in the present disclosure, the entire surface of the planographic printing plate precursor may be heated as necessary before exposure, in the middle of exposure, or during a period of time from exposure to development. By such heating, an image forming reaction in the image recording layer is promoted, and advantages such as improvement in sensitivity or printing durability and stabilization of sensitivity can be obtained. Heating before development is preferably performed in a mild condition of 150°C or lower. In the above-described aspect, it is possible to prevent a problem of the curing of the non-image area. As the heating after development, an extremely strong condition is preferably used, and a range of 100°C to 500°C is preferable. In the above-described range, a sufficient image-strengthening action is obtained, and it is possible to suppress problems such as the deterioration of the support and the thermal decomposition of the image area.

### Examples

Hereinafter, the present disclosure will be described in detail with reference to examples, but the present disclosure is not limited thereto. In the present examples, "%" and "parts" respectively indicate "% by mass" and "parts by mass" unless otherwise specified. In a polymer compound, the molecular weight indicates the weight-average molecular weight (Mw) and the proportion of constitutional repeating units indicates mole percentage unless otherwise specified. In addition, the weight-average molecular weight (Mw) is a value in terms of polystyrene obtained by performing measurement using a gel permeation chromatography (GPC) method.

In addition, polymers P-1 to P-12 in examples are the same as polymers P-1 to P-12 which are specific examples of the polymer A described above.

### <Synthesis of polymer P-6>

78.00 g of 1-methoxy-2-propanol was weighed and placed in a three-neck flask and heated to 70°C under a nitrogen stream. A mixed solution consisting of 52.8 g of BLEMMER PME-100 (methoxydiethylene glycol monomethacrylate, manufactured by NOF CORPORATION), 2.8 g of methyl methacrylate, 25.0 g of methacrylic acid, 6.4 g of hexakis(3-mercaptopropionic acid) dipentaerythritol, 1.1 g of V-601 (dimethyl 2,2'-azobis(isobutyrate), manufactured by Wako Pure Chemical Corporation), and 55 g of 1-methoxy-2-propanol was added dropwise to the reaction vessel over 2 hours 30 minutes. After the dropwise addition, the reaction was continued for another 2 hours. 2 hours later, a mixed solution consisting of 0.11 g of V-601 and 1 g of 1-methoxy-2-propanol was added thereto, the temperature was raised to 90°C, and the reaction was continued for 2.5 hours. After the reaction, the reaction solution was cooled to room temperature.

177.2 g of 1-methoxy-2-propanol, 0.28 g of 4-hydroxytetramethylpiperidine-N-oxide, 46.0 g of glycidyl methacrylate, and 3.4 g of tetrabutylammonium bromide were added to the reaction solution, and the reaction solution was well stirred and heated to 90°C.

18 hours later, the reaction solution was cooled to room temperature (25°C), and then 114.5 g of 1-methoxy-2-propanol was added to the reaction solution to dilute the reaction solution.

The obtained polymer P-6 in this manner had a concentration of solid contents of 23% by mass, and a weight-average molecular weight in terms of polystyrene measured by GPC of 15,000.

By using the same method as the synthesizing method of the polymer P-6 and appropriately adjusting the type and amount of monomer, polymers P-1 to P-5, P-7 and P-8, and P-11 and polymers Q-1 to Q-3 shown in the following table were synthesized.

**[Table 2]**

| Polymer A | *Thiol unit | Constitutional unit A1 | mol % | Constitutional unit B1 | mol % | Constitutional unit C1 | mol % | *Sulfur content | *Mw |
|---|---|---|---|---|---|---|---|---|---|
| Q-1 | SH5 | 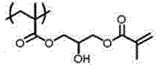 | 10 | 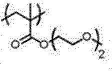 | 40 | 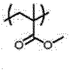 | 50 | 0.2 | 65000 |
| Q-2 | SH5 | 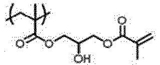 | 10 | 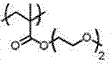 | 39 | 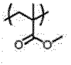 | 49 | 1.7 | 10000 |
| Q-3 | SH5 | 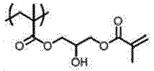 | 50 | 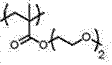 | 40 | 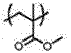 | 10 | 0.2 | 70000 |

| | | | | | | | | | |
|---|---|---|---|---|---|---|---|---|---|
| * "Thiol unit" represents the constitutional unit derived from polyfunctional thiol unit. * "Sulfur content" represents the content of sulfur atom (% by mass). * "Mw" represents the weight-average molecular weight. | | | | | | | | | |

In the above table, the description of mol% in the columns of constitutional unit A1 to constitutional unit C1 indicates the content (mol%) of each constitutional unit in the polymer.

Here, in Q-1, the content of the constitutional unit A1 is 10 mol%, the content of the constitutional unit B1 is 40 mol%, the content of the constitutional unit C1 is 50 mol%, and the content of a constitutional unit SH5 derived from a polyfunctional thiol compound is 0.25 mol%. In the above table, the constitutional unit derived from the polyfunctional thiol compound is the same as SH5 described in the specific examples of the polymer A described above.

Similarly, in Q-3, the content of the constitutional unit SH5 is 0.25 mol%, and in Q-2, the content of the constitutional unit SH5 is 2 mol%.

### <Synthesis of polymer P-9>

92.3 g of methyl ethyl ketone was weighed and placed in a three-neck flask and heated to 70°C under a nitrogen stream. A mixed solution consisting of 32.9 g of BLEMMER PME-100 (methoxydiethylene glycol monomethacrylate, manufactured by NOF CORPORATION), 14.9 g of tert-buthyl methacrylate, 54.7 g of hydroxyethyl methacrylate, 6.6 g of hexakis(3-mercaptopropionic acid) dipentaerythritol, 2.5 g of V-65 (2,2'-azobis(2,4-dimethylvaleronitrile), manufactured by Wako Pure Chemical Corporation), and 61.5 g of methyl ethyl ketone was added dropwise to the reaction vessel over 2 hours. After the dropwise addition, the reaction was continued for another 2 hours. 2 hours later, a mixed solution consisting of 0.3 g of V-65 and 2 g of methyl ethyl ketone was added thereto, the temperature was raised to 75°C, and the reaction was continued for 2 hours. After the reaction, the reaction solution was cooled to room temperature.

204.7 g of methyl ethyl ketone, 0.34 g of 4-hydroxytetramethylpiperidine-N-oxide, and 58.1 g of 2-isocyanatoethyl acrylate were added to the reaction solution, and the reaction solution was well stirred and heated to 60°C. After confirming that the temperature was stabilized, a mixed solution consisting of 0.35 g of NEOSTANN U-600 manufactured by Nitto Kasei Co., Ltd. and 2 g of methyl ethyl ketone was added thereto, and the reaction was performed for 10 hours.

The obtained polymer P-9 in this manner had a concentration of solid contents of 29% by mass, and a weight-average molecular weight in terms of polystyrene measured by GPC of 20,000.

By using the same method as the synthesizing method of the polymer P-9 and appropriately adjusting the type and amount of monomer, a polymer P-12 was synthesized.

### <Synthesis of polymer P-10>

111.2 g of methyl ethyl ketone was weighed and placed in a three-neck flask and heated to 70°C under a nitrogen stream. A mixed solution consisting of 79.1 g of BLEMMER PME-100 (methoxydiethylene glycol monomethacrylate, manufactured by NOF CORPORATION), 7.2 g of FA-513AS (dicyclopentanyl acrylate, manufactured by Hitachi Chemical Co., Ltd.), 21.1 g of methacrylic acid, 15.4 g of hexakis(3-mercaptopropionic acid) dipentaerythritol, 2.9 g of V-65 (2,2'-azobis(2,4-dimethylvaleronitrile), manufactured by Wako Pure Chemical Corporation), and 77.3 g of methyl ethyl ketone was added dropwise to the reaction vessel over 2 hours. After the dropwise addition, the reaction was continued for another 2 hours. 2 hours later, a mixed solution consisting of 0.3 g of V-65 and 2 g of methyl ethyl ketone was added thereto, the temperature was raised to 75°C, and the reaction was continued for 2 hours. After the reaction, the reaction solution was cooled to room temperature.

186.7 g of methyl ethyl ketone, 0.33 g of 4-hydroxytetramethylpiperidine-N-oxide, 36.6 g of glycidyl methacrylate, and 4.2 g of tetrabutylammonium bromide were added to the reaction solution, and the reaction solution was well stirred and heated to 75°C.

24 hours later, the reaction solution was cooled to room temperature, 34.6 g of 2-isocyanatoethyl acrylate and 226.2 g of methyl ethyl ketone were added to the reaction solution, and the reaction solution was well stirred and heated to 60°C. After confirming that the temperature was stabilized, a mixed solution consisting of 0.35 g of NEOSTANN U-600 manufactured by Nitto Kasei Co., Ltd. and 2 g of methyl ethyl ketone was added thereto, and the reaction was performed for 10 hours.

The obtained polymer P-10 in this manner had a concentration of solid contents of 25% by mass, and a weight-average molecular weight in terms of polystyrene measured by GPC of 9000.

### (Examples 1 to 14 and Comparative Examples 1 to 3)

### <Production of support>

A 0.3 mm-thick aluminum alloy plate of material 1S was subjected to from (A-a) mechanical roughening treatment (brush grain method) described in paragraph 0126 of JP2012-158022A to (A-i) desmutting treatment in an acidic aqueous solution described in paragraph 0134.

Next, by appropriately adjusting each treatment condition from (A-j) first step anodizing treatment described in paragraph 0135 of JP2012-158022A to (A-m) third step anodizing treatment described in paragraph 0138, an anodized film which has a large-diameter hole portion having an average diameter of 35 nm and a depth of 100 nm and a small-diameter hole portion having an average diameter of 10 nm and a depth of 1000 nm, in which a ratio of the depth of the large-diameter hole portion to the average diameter of the large-diameter hole portion was 2.9, was formed, thereby obtaining an aluminum support A.

Between all treatment steps, a water washing treatment was performed, and liquid cutting was performed using a nip roller after the water washing treatment.

### <Formation of undercoat layer>

The support A was coated with an undercoat layer coating solution (1) having the following composition such that a dried coating amount was set to 20 mg/m², thereby forming an undercoat layer.

### <Undercoat layer coating solution (1)>

· Polymer (U-1) [the following structure]: 0.18 parts by mass
· Hydroxyethyl imino diacetic acid: 0.10 parts by mass
· Water: 61.4 parts by mass

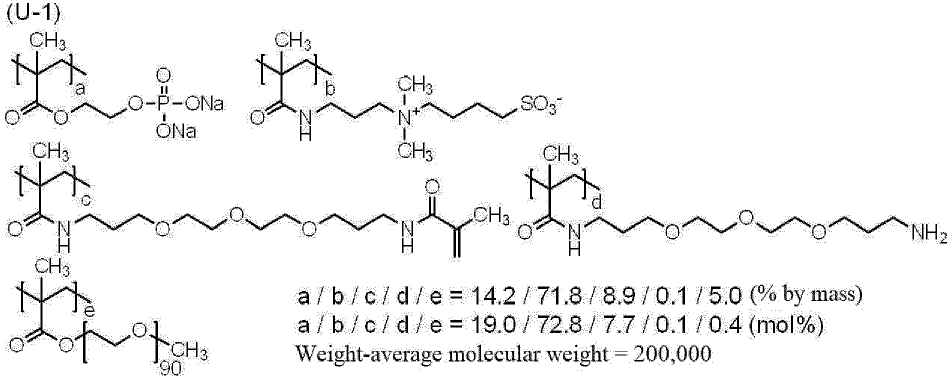

### <Formation of image recording layer>

The undercoat layer was bar-coated with an image recording layer coating solution (1) having the following composition and dried in the oven at 100°C for 60 seconds, thereby forming an image recording layer having a dried coating amount of 1.0 g/m².

The image recording layer coating solution (1) was prepared by mixing and stirring the following photosensitive solution (1) and the microgel solution immediately before the coating.

### [Photosensitive solution (1)]

· Polymer A shown in Table 3: Amount shown in Table 3
· Infrared absorbent (D-1) [compound having the following structure]: 0.024 parts by mass
· Electron-accepting polymerization initiator (E-1) [compound having the following structure]: 0.245 parts by mass
· Polymerizable compound (tris(acryloyloxyethyl) isocyanurate (NK ESTER A-9300, manufactured by Shin-Nakamura Chemical Co., Ltd.)): 0.192 parts by mass
· Borate compound (electron-donating polymerization initiator): tetraphenyl borate (TPB) [compound having the following structure]: 0.020 parts by mass
· Low-molecular weight hydrophilic compound (tris(2-hydroxyethyl) isocyanurate): 0.062 parts by mass
· Fluorine-based surfactant (1) [described below]: 0.008 parts by mass
· Acid color developing agent: S-205 (manufactured by Fukui Yamada Chemical Co., Ltd.): 0.030 parts by mass
· 2-butanone: 1.091 parts by mass
· 1-methoxy-2-propanol: 8.609 parts by mass

### [Microgel solution]

· Microgel (1): 2.640 parts by mass
· Distilled water: 2.425 parts by mass

The structures of the infrared absorbent (D-1), electron-accepting polymerization initiator (E-1), and fluorine-based surfactant (1) used in the photosensitive solution (1) are shown below.

In the structure of the fluorine-based surfactant (1), subscripts in parentheses showing each constitutional unit indicate the content ratio (molar ratio) of each constitutional unit, and subscripts in parentheses showing an ethylene oxide structure or a propylene oxide structure indicate the repetition number of each structure.

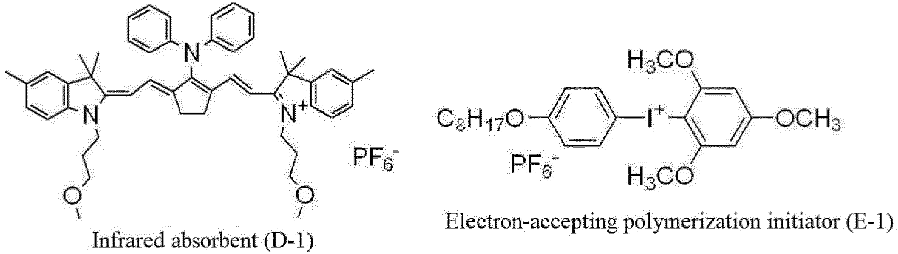

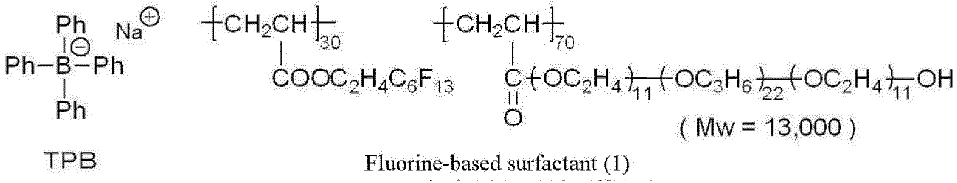

A method of preparing the microgel (1) used in the microgel solution will be described below.

### [Preparation of polyvalent isocyanate compound (1)]

43 mg of bismuth tris(2-ethylhexanoate) (NEOSTAN U-600, manufactured by Nitto Kasei Co., Ltd.) was added to an ethyl acetate (25.31 g) suspended solution of 17.78 g (80 mmol) of isophorone diisocyanate and 7.35 g (20 mmol) of the following polyhydric phenol compound (1), and the solution was stirred. The reaction temperature was set to 50°C in a case of heat generation being subsided, and the solution was stirred for 3 hours, thereby obtaining an ethyl acetate solution (50% by mass) of a polyvalent isocyanate compound (1).

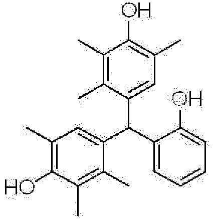

### Polyhydric phenol compound (1)

### [Preparation of microgel (1)]

The following oil phase components and the water phase component were mixed with each other and emulsified at 12,000 rpm for 10 minutes using a homogenizer. The obtained emulsion was stirred at 45°C for 4 hours, 5.20 g of a 10% by mass of aqueous solution of 1,8-diazabicyclo[5.4.0]undeca-7-ene-octylate (U-CAT SA102, manufactured by San-Apro Ltd.) was added thereto, and the solution was stirred at room temperature for 30 minutes and allowed to stand at 45°C for 24 hours. Adjustment was made using distilled water so that the concentration of the solid content reached 20% by mass, thereby obtaining an aqueous dispersion liquid of a microgel (1). Using a dynamic light scattering particle size distribution analyzer LB-500 (manufactured by HORIBA, Ltd.), the volume average particle diameter measured by a light scattering method was 0.28 µm.

### -Oil phase components-

· (Component 1) ethyl acetate: 12.0 parts by mass
· (Component 2) adduct (50% by mass of ethyl acetate solution, manufactured by Mitsui Chemicals, Inc.) obtained by adding trimethylolpropane (6 mol) and xylene diisocyanate (18 mol) and adding methyl one-terminal polyoxyethylene (1 mol, repetition number of oxyethylene units: 90) thereto: 3.76 parts by mass
· (Component 3) polyvalent isocyanate compound (1) (as 50% by mass of ethyl acetate solution): 15.0 parts by mass
· (Component 4) 65% by mass of solution of dipentaerythritol pentaacrylate (SR-399, manufactured by Sartomer Japan Inc.) in ethyl acetate: 11.54 parts by mass
· (Component 5) 10% solution of sulfonate type surfactant (PIONINE A-41-C, manufactured by TAKEMOTO OIL & FAT Co., Ltd.) in ethyl acetate: 4.42 parts by mass

### -Water phase component-

· Distilled water: 46.87 parts by mass

### <Formation of protective layer>

The image recording layer was bar-coated a the protective layer coating solution having the following composition and dried in the oven at 120°C for 60 seconds, thereby forming a protective layer having a dried coating amount of 0.15 g/m².

### <Protective layer coating solution>

· Inorganic layered compound dispersion liquid (1) [described below]: 1.5 parts by mass
· 6% by mass of aqueous solution of polyvinyl alcohol (CKS50, manufactured by The Nippon Synthetic Chemical Industry Co., Ltd., sulfonic acid-modified, saponification degree: 99 mol% or more, degree of polymerization: 300): 0.55 parts by mass
· 6% by mass of aqueous solution of polyvinyl alcohol (PVA-405, manufactured by Kuraray Co., Ltd., saponification degree: 81.5 mol%, degree of polymerization: 500): 0.03 parts by mass
· 1% by mass of aqueous solution of surfactant (polyoxyethylene lauryl ether, EMALEX 710, manufactured by Nihon Emulsion Co., Ltd.): 0.86 parts by mass
· Ion exchange water: 6.0 parts by mass

A method of preparing the inorganic layered compound dispersion liquid (1) will be described below.

### [Preparation of inorganic layered compound dispersion liquid (1)]

6.4 g of synthetic mica (SOMASIF ME-100, manufactured by Co-op Chemical Co., Ltd.) was added to 193.6 g of ion exchange water and was dispersed using a homogenizer until the average particle diameter (the laser scattering method) reached 3 µm. The aspect ratio of the obtained dispersed particles was 100 or greater.

### <Evaluation of planographic printing plate precursor>

For the respective planographic printing plate precursor described above, on-press developability and oil printing durability were evaluated using the following evaluation methods. The evaluation results are shown in Table 3.

### [On-press developability]

Each of the planographic printing plate precursors was exposed using Luxel PLATESETTER T-6000III (manufactured by Fujifilm Corporation) equipped with an infrared semiconductor laser under conditions of an external drum rotation speed of 1,000 rpm, a laser output of 70%, and a resolution of 2,400 dpi (dot per inch, 1 inch is 2.54 cm). The exposed image had a solid image and a 50% halftone dot chart of a frequency modulation screen (FM screen) having dots with a diameter of 20 µm.

The exposed planographic printing plate precursor was attached to a plate cylinder of a printing press LITHRONE26 (manufactured by KOMORI Corporation) without performing a development treatment. Dampening water and ink were supplied according to a standard automatic printing start method of the printing press LITHRONE26 (manufactured by KOMORI Corporation) using dampening water in which the volume ratio of Ecolity-2 (manufactured by Fujifilm Corporation) to tap water was 2/98 and Values-G(N) BLACK INK (manufactured by DIC Graphics Corporation), and then printing was performed on 100 sheets of Tokubishi Art paper (76.5 kg) (manufactured by Mitsubishi Paper Mills, Ltd.) at a printing speed of 10,000 sheets per hour.

The on-press developability was evaluated by measuring the number of sheets of printing paper required for the on-press development of the unexposed area of the image recording layer on the printing press to be completed and for the ink not to be transferred to the non-image area. As the number of sheets is smaller, on-press developability is excellent.

### [Oil printing durability]

After the evaluation of on-press developability, printing was further continued. With an increase in number of printed sheets, the ink density in the printed material was decreased since the image recording layer was gradually worn out. The number of printed sheets in which a value obtained by measuring a halftone dot area ratio of 50% halftone dot of FM screen in the printed material using a Gretag densitometer was decreased by 5% from the measured value on the 100th printed material was measured. As shown in the following equation, printing durability was evaluated based on a relative printing durability which was set to 100 in a case where the number of printed sheets was 50,000. As the value increases, oil printing durability (printing durability) is excellent.

Relative printing durability = (number of printed sheets of target planographic printing plate precursor)/50,000 × 100

### [Spot scumming]

The obtained planographic printing plate precursor was humidified together with an interleaving paper for 1 hour in an environment of 25°C and 70% RH, wrapped with an aluminum kraft paper, and then heated in an oven set at 60°C for 5 days. Thereafter, the temperature was lowered to room temperature, the on-press development was performed using the same printing press and method as described above, and 500 sheets were printed. The 500th printed material was visually checked, and the number of printing stains of 20 µm or more per 100 cm² was calculated.

A case where the number of spot scumming per 100 cm² was less than 50 was A, a case where the number of spot scumming per 100 cm² was 50 or more and less than 100 was B, and a case where the number of spot scumming per 100 cm² was 100 or more was C. It can be said that A is the most excellent in suppressing spot scumming, and C is the least inferior in suppressing spot scumming.

### [UV printing durability]

Using Magnus 800 Quantum manufactured by Kodak and equipped with an infrared semiconductor laser, the planographic printing plate precursor produced as described above was exposed with light (corresponding to an exposure energy of 110 mJ/cm²) under conditions of an output of 27 W, an external drum rotation speed of 450 rpm, and a resolution of 2,400 dpi. The exposure image included a solid image and a 3% halftone dot chart of an amplitude modulation screen (AM screen).

The obtained exposed precursor was attached to a cylinder of a printing press SX-74 (manufactured by Heidelberg) of Kikuban size (636 mm × 939 mm) without performing a development treatment. The printing press was connected to a 100 L dampening water circulation tank incorporating a nonwoven filter and a temperature controlling device. 80 L of a 2.0% dampening water S-Z1 (manufactured by Fujifilm Corporation) is charged in a circulation device, dampening water and ink were supplied according to a standard automatic printing start method using T&K UV OFS K-HS solid ink GE-M (manufactured by T&K TOKA CO., LTD.) as printing ink, and then printing was performed on Tokubishi Art paper (76.5 kg) at a printing speed of 10,000 sheets per hour.

With an increase in number of printed sheets, the ink density in the printed material was decreased since the image area was gradually worn out. The number of copies in which a value obtained by measuring a halftone dot area ratio of 3% halftone dot of AM screen in the printed material using a Gretag densitometer (manufactured by Gretag Macbeth) was decreased by 1% from the measured value on the 500th printed material was defined as the number of printed sheets to evaluate printing durability. Printing durability was evaluated based on a relative printing durability which was set to 100 in a case where the number of printed sheets was 50,000. As the value increases, UV printing durability is excellent. Relative printing durability = (number of printed sheet of target planographic printing plate precursor)/50,000 × 100

**[Table 3]**

| | Polymer A (parts by mass) | Oil printing durability | On-press developability | UV printing durability | Spot scumming |
|---|---|---|---|---|---|
| Example 1 | P-1 (0.150) | 82 | 15 | 78 | A |
| Example 2 | P-2 (0.180) | 89 | 10 | 75 | A |
| Example 3 | P-3 (0.100) | 92 | 12 | 80 | A |
| Example 4 | P-4 (0.230) | 96 | 8 | 85 | A |
| Example 5 | P-5 (0.200) | 85 | 11 | 73 | A |
| Example 6 | P-6 (0.130) | 94 | 9 | 82 | A |
| Example 7 | P-7 (0.140) | 87 | 10 | 79 | A |
| Example 8 | P-8 (0.100) | 84 | 14 | 69 | A |
| Example 9 | P-9 (0.270) | 96 | 15 | 77 | A |
| Example 10 | P-10 (0.220) | 91 | 16 | 75 | A |
| Example 11 | P-11 (0.180) | 88 | 12 | 92 | A |
| Example 12 | P-12 (0.160) | 86 | 13 | 88 | A |
| Example 13 | P-6, Q-1 (0.050), (0.130) | 87 | 15 | 81 | A |
| Example 14 | P-13 (0.190) | 90 | 18 | 83 | A |
| Comparative Example 1 | Q-1 (0.160) | 70 | 30 | 40 | B |
| Comparative Example 2 | Q-2 (0.200) | 50 | 20 | 31 | B |
| Comparative Example 3 | Q-3 (0.180) | 73 | 40 | 42 | C |

In Table 3, the description of the column of polymer A respectively indicates the type of the polymer A used and the amount (parts by mass) used in the photosensitive solution (1). The description of "P-6, Q-1 (0.050), (0.130)" in Example 13 indicates that 0.050 parts by mass of the polymer P-6 was used and 0.130 parts by mass of the polymer Q-1 was used.

### (Examples 15 to 18 and Comparative Examples 4 to 6)

The following support C was used instead of the support A as a support, and the support was bar-coated with, instead of the image recording layer coating solution (1), an image recording layer coating solution (2) having the following composition and dried in the oven at 70°C for 60 seconds, thereby forming an image recording layer having a dried coating amount of 0.6 g/m² and thus producing a planographic printing plate precursor. The undercoat layer and the protective layer was not formed.

### <Production of support C>

In order to remove rolling oil on the surface of a 0.3 mm-thick aluminum plate (material JIS A 1050), a defatting treatment was performed thereon using a 10% by mass aqueous solution of sodium aluminate at 50°C for 30 seconds, and then the surface of the aluminum plate was grained using three implanted nylon brushes having a hair diameter of 0.3 mm and an aqueous suspension (specific gravity: 1.1 g/cm³) of pumice having a median diameter of 25 µm and well washed with water. The aluminum plate was etched by being immersed in a 25% by mass aqueous solution of sodium hydroxide at 45°C for 9 seconds, washed with water, further immersed in a 20% by mass nitric acid aqueous solution at 60°C for 20 seconds, and then washed with water. The etching amount of the grained surface was approximately 3 g/m².

Next, an electrochemical roughening treatment was continuously performed using an AC voltage of 60 Hz. An electrolyte was a 1% by mass aqueous solution of nitric acid (including 0.5% by mass of aluminum ions), and the solution temperature was 50°C. Using a trapezoidal rectangular waveform AC having a time TP, until the current value reached a peak from zero, of 0.8 ms and the duty ratio of 1:1 as the AC power source waveform, the electrochemical roughening treatment was performed using a carbon electrode as a counter electrode. As an auxiliary anode, ferrite was used. The current density was 30 A/dm² as the peak current value, and 5% of the current from the power source separately flowed to the auxiliary anode. The electric quantity in nitric acid electrolysis was 175 C/dm² as the electric quantity in a case of anodization of the aluminum plate. Thereafter, washing with water by spraying was performed.

Next, an electrochemical roughening treatment was performed according to the same method as that for the nitric acid electrolysis using a 0.5% by mass of hydrochloric acid aqueous solution (containing 0.5% by mass of aluminum ions) and an electrolyte having a solution temperature of 50°C under a condition of an electric quantity of 50 C/dm² in a case of anodization of the aluminum plate, and washing with water was performed using a spray.

Next, 2.5 g/m² of a DC anodized film was formed on the aluminum plate at a current density of 15 A/dm² using a 22% by mass aqueous solution of phosphoric acid as an electrolyte and then washed with water and dried, thereby producing a support B. The average pore diameter in the surface layer of the anodized film (surface average pore diameter) was 25 nm.

The pore diameter in the surface layer of the anodized film was measured using a method in which the surface was observed an ultrahigh resolution SEM (Hitachi S-900) at a relatively low acceleration voltage of 12 V at a magnification of 150,000 times without carrying out a vapor deposition treatment or the like for imparting conductive properties, 50 pores were randomly extracted, and the average value was obtained. The standard deviation was ±10% or less.

Thereafter, in order to ensure hydrophilicity of the non-image area, the support B was subjected to a silicate treatment at 60°C for 10 seconds using a 2.5% by mass of a No. 3 sodium silicate aqueous solution and then washed with water, thereby producing a support C. The adhesion amount of Si was 10 mg/m². The center line average roughness (Ra) of the support C measured using a needle having a diameter of 2 µm was 0.51 µm.

### <Image recording layer coating solution (2)>

· Polymer A shown in Table 4: Amount shown in Table 4
· Infrared absorbent (D-2) [compound having the following structure]: 0.018 parts by mass
· Electron-accepting polymerization initiator (I-2) [compound having the following structure]: 0.050 parts by mass
· Borate compound TPB [compound having the following structure]: 0.010 parts by mass
· Aqueous dispersion liquid of polymer particles (1) (22% by mass) [compound having the following structure]: 10.0 parts by mass
· Dipentaerythritol hexaacrylate A-DPH (manufactured by Shin-Nakamura Chemical Co., Ltd.): 0.20 parts by mass
· Dipentaerythritol pentaacrylate, hexamethylene diisocyanate, urethane pre-polymer UA-510H (manufactured by Kyoeisha Chemical Co., Ltd.): 0.20 parts by mass
· Ethoxylated pentaerythritol tetraacrylate ATM-4E (manufactured by Shin-Nakamura Chemical Co., Ltd.): 0.20 parts by mass
· Acid color developing agent: 0.050 parts by mass of Black-XV (manufactured by Yamamoto Chemicals Inc.)

· Mercapto-3-triazole: 0.2 parts by mass
   · Byk 336 (manufactured by BYK-Chemie Japan K. K.): 0.4 parts by mass
   · Klucel M (manufactured by Hercules, Inc.): 4.8 parts by mass
   · ELVACITE 4026 (manufactured by Ineos Acrylics): 2.5 parts by mass
   · n-propanol: 55.0 parts by mass
   · 2-butanone: 17.0 parts by mass

The infrared absorbent (D-2), the electron-accepting polymerization initiator (I-2), and the compounds described by trade names used in the image recording layer coating solution (2) are as follows.

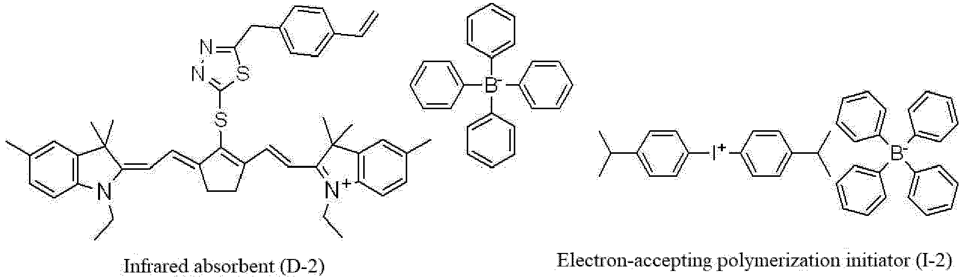

· SR-399: dipentaerythritol pentaacrylate
· Byk 336: modified dimethyl polysiloxane copolymer (25% by mass xylene/methoxy propyl acetate solution)
· Klucel M: hydroxypropyl cellulose (2% by mass aqueous solution)
· ELVACITE 4026: highly branched polymethyl methacrylate (10% by mass 2-butanone solution)

A method of preparing the aqueous dispersion liquid of polymer particles (1) used in the image recording layer coating solution (2) will be described below.

### [Preparation of aqueous dispersion liquid of polymer particles (1)]

Nitrogen gas was introduced into a four-neck flask equipped with a stirrer, a thermometer, a dropping funnel, a nitrogen introduction pipe, and a reflux condenser to perform deoxygenation, 10 g of polyethylene glycol methyl ether methacrylate (PEGMA, average number of repeating units of ethylene glycol: 50), 200 g of distilled water, and 200 g of n-propanol were added thereto, and then the mixture was heated until the internal temperature thereof was set to 70°C. Next, a mixture of 10 g of styrene (St), 80 g of acrylonitrile (AN), and 0.8 g of 2,2'-azobisisobutyronitrile prepared in advance was added dropwise thereto for 1 hour. After the dropwise addition, the reaction was continued for 5 hours, 0.4 g of 2,2'-azobisisobutyronitrile was added thereto, and the mixture was heated until the internal temperature was set to 80°C. Subsequently, 0.5 g of 2,2'-azobisisobutyronitrile was added thereto for 6 hours. The total degree of polymerization at the stage of the continued reaction for 20 hours was 98% or more based on mole, and an aqueous dispersion liquid of polymer particles (1) having PEGMA, St, and AN at a mass ratio of 10/10/80 was prepared. The particle size distribution of the polymer particles has a maximum value at 150 nm of the particle diameter.

The particle size distribution was acquired by imaging an electron micrograph of polymer particles, measuring the total number of 5,000 particle diameters of the particles on the photograph, dividing the interval from the maximum value of the obtained measured value of the particle diameter to 0 into the logarithmic scale of 50, and plotting the appearance frequency of each particle diameter. Regarding non-spherical particles, a particle diameter value of spherical particles which have the same particle area with the particle area on the photograph was set to a particle diameter of the non-spherical particles.

### <Evaluation of planographic printing plate precursor>

Each of the on-press developability, oil printing durability, spot scumming, and UV printing durability was evaluated by the same methods as in Example 1. The evaluation results are shown in Table 4.

**[Table 4]**

| | Polymer A (parts by mass) | Oil printing durability | On-press developability | UV printing durability | Spot scumming |
|---|---|---|---|---|---|
| Example 15 | P-4 (0.230) | 90 | 11 | 85 | A |
| Example 16 | P-6 (0.220) | 92 | 8 | 90 | A |
| Example 17 | P-10 (0.150) | 85 | 15 | 81 | A |
| Example 18 | P-6, X-1 (0.100), (0.200) | 89 | 20 | 90 | A |
| Comparative Example 4 | Q-1 (0.160) | 65 | 43 | 50 | B |
| Comparative Example 5 | Q-2 (0.200) | 40 | 21 | 25 | B |
| Comparative Example 6 | Q-3 (0.180) | 57 | 38 | 40 | C |

### (Examples 19 to 21 and Comparative Examples 7 to 9)

Planographic printing plate precursors were produced in the same method as in Example 1, except that the type and addition amount of "polymer A shown in Table 3" included in the photosensitive solution (1) in Example 1 were changed as shown in Table 5.

### <Development treatment>

Using Clean Out Unit+ C85 manufactured by Glunz & Jensen, a development treatment was performed on the exposed planographic printing plate at 25°C.

Here, "development treatment" refers to a complex treatment including, in addition to the development of the image recording layer, one or more treatments selected from the group consisting of the removal of the protective layer, gum pulling, and drying. As a treatment liquid used for the development treatment, a developer having the following composition was used. In the development treatment, water washing treatment was not performed.

### [Developer]

· PELEX NBL (sodium alkylnaphthalenesulfonate, anionic surfactant manufactured by Kao Corporation): 7.8 parts by mass
· NEWCOL B13 (polyoxyethylene aryl ether, non-ionic surfactant manufactured by Nippon Nyukazai Co., Ltd.): 2.00 parts by mass
· SURFYNOL 2502 (manufactured by Air Products and Chemicals, Inc.): 0.6 parts by mass
· Benzyl alcohol (manufactured by Wako Pure Chemical Corporation): 0.8 parts by mass
· Sodium gluconate (manufactured by Fuso Chemical Co., Ltd.): 3.0 parts by mass
· Disodium hydrogen phosphate (manufactured by Wako Pure Chemical Corporation): 0.3 parts by mass
· Sodium bicarbonate (manufactured by Wako Pure Chemical Corporation): 0.3 parts by mass
· Antifoaming agent (SILCOLAPSE432 manufactured by Bluestar Silicones USA Corp.): 0.01 parts by mass
· Water: 85.49 parts by mass

### <Evaluation of planographic printing plate precursor>

### [Oil printing durability]

The developed planographic printing plate was attached to a plate cylinder of a printing press LITHRONE26 (manufactured by KOMORI Corporation). Dampening water and ink were supplied according to a standard automatic printing start method of the printing press LITHRONE26 (manufactured by KOMORI Corporation) using dampening water in which the volume ratio of Ecolity-2 (manufactured by Fujifilm Corporation) to tap water was 2/98 and Values-G(N) BLACK INK (manufactured by DIC Graphics Corporation), and then printing was performed on Tokubishi Art paper (ream weight: 76.5 kg) (manufactured by Mitsubishi Paper Mills, Ltd.) at a printing speed of 10,000 sheets per hour. With an increase in number of printed sheets, the ink density in the printed material was decreased since the image recording layer was gradually worn out. The number of printed sheets in which a value obtained by measuring a halftone dot area ratio of 50% halftone dot of FM screen in the printed material using a Gretag densitometer was decreased by 5% from the measured value on the 100th printed material was measured. As shown in the following equation, printing durability was evaluated based on a relative printing durability which was set to 100 in a case where the number of printed sheets was 50,000. As the value increases, oil printing durability (printing durability) is excellent. Relative printing durability = ((number of printed sheets of target planographic printing plate precursor)/50,000) × 100

### [UV printing durability]

The developed planographic printing plate was attached to a cylinder of a printing press SX-74 (manufactured by Heidelberg). The printing press was connected to a 100 L dampening water circulation tank incorporating a nonwoven filter and a temperature controlling device. 80 L of a 2.0% dampening water S-Z1 (manufactured by Fujifilm Corporation) is charged in a circulation device, dampening water and ink were supplied according to a standard automatic printing start method using T&K UV OFS K-HS solid ink GE-M (manufactured by T&K TOKA CO., LTD.) as printing ink, and then printing was performed on Tokubishi Art paper (ream weight: 76.5 kg) at a printing speed of 10,000 sheets per hour.

With an increase in number of printed sheets, the ink density in the printed material was decreased since the image area was gradually worn out. The number of copies in which a value obtained by measuring a halftone dot area ratio of 3% halftone dot of AM screen in the printed material using a Gretag densitometer (manufactured by Gretag Macbeth) was decreased by 1% from the measured value on the 500th printed material was defined as the number of printed sheets to evaluate printing durability. Printing durability was evaluated based on a relative printing durability which was set to 100 in a case where the number of printed sheets was 50,000. As the value increases, UV printing durability is excellent. Relative printing durability = (number of printed sheets of target planographic printing plate precursor)/50,000 × 100

**[Table 5]**

| | Polymer A (parts by mass) | Oil printing durability | UV printing durability |
|---|---|---|---|
| Example 19 | P-2 (0.230) | 81 | 80 |
| Example 20 | P-6 (0.280) | 85 | 76 |
| Example 21 | P-10 (0.250) | 90 | 82 |
| Comparative Example 7 | Q-1 (0.230) | 65 | 39 |
| Comparative Example 8 | Q-2 (0.230) | 49 | 29 |
| Comparative Example 9 | Q-3 (0.240) | 69 | 35 |

From the results shown in Tables 3 and 4, it is understood that the planographic printing plate precursor according to the embodiment of the present disclosure provides a planographic printing plate having excellent printing durability.

In addition, from the results shown in Tables 3 and 4, it is understood that the planographic printing plate precursor according to the examples of the present disclosure provides a planographic printing plate having excellent suppression in UV printing durability and spot scumming.

Furthermore, from the results shown in Tables 3 and 4, it is understood that the planographic printing plate precursor according to the examples of the present disclosure has excellent on-press developability.

From the results shown in Table 5, it is understood that the planographic printing plate precursor according to the embodiment of the present disclosure has excellent printing durability of the obtained planographic printing plate even in a case of performing a development treatment using a developer.

In addition, from the results shown in Table 5, it is understood that the planographic printing plate precursor according to the examples of the present disclosure has excellent UV printing durability of the obtained planographic printing plate even in a case of performing a development treatment using a developer.

## Claims

1. A planographic printing plate precursor comprising:
a support; and
an image recording layer formed on the support,
wherein the image recording layer contains a polymer A which includes a constitutional unit A1 having an ethylenically unsaturated group,
wherein a weight-average molecular weight of the polymer A is in a range of 2,500 to 35,000,
a content of the constitutional unit A1 in the polymer A is 15 mol% or more; and
the sulfur content of the polymer A is in a range of 0.5% by mass to 10% by mass with respect to a total mass of the polymer A,
wherein the sulfur content derives from a constitutional unit derived from a monofunctional thiol compound or a bifunctional thiol compound, or a constitutional unit derived from a polyfunctional thiol compound having 3 to 10 functional groups.

2. The planographic printing plate precursor according to claim 1,
wherein the weight-average molecular weight of the polymer A is in a range of 2,500 to 20,000, and
the content of the constitutional unit A1 in the polymer A is 30 mol% or more.

3. The planographic printing plate precursor according to any one of claims 1 to 2,
wherein the polymer A is a star polymer including a constitutional unit derived from a polyfunctional thiol compound having 3 to 10 functional groups.

4. The planographic printing plate precursor according to any one of claims 1 to 3,
wherein the ethylenically unsaturated group in the polymer A is a (meth)acryloxy group.

5. The planographic printing plate precursor according to any one of claims 1 to 4,
wherein the polymer A includes a constitutional unit including an ether bond as a constitutional unit B 1 having a hydrophilic group.

6. The planographic printing plate precursor according to any one of claims 1 to 5,
wherein the image recording layer further includes a polymerizable compound and an electron-accepting polymerization initiator.

7. The planographic printing plate precursor according to any one of claims 1 to 6,
wherein the image recording layer further includes an infrared absorbent.

8. The planographic printing plate precursor according to any one of claims 1 to 7,
wherein the image recording layer further includes an acid color developing agent.

9. The planographic printing plate precursor according to any one of claims 1 to 8,
wherein the image recording layer further includes polymer particles.

10. The planographic printing plate precursor according to any one of claims 1 to 9,
wherein the planographic printing plate precursor is a planographic printing plate precursor for on-press development.

11. The planographic printing plate precursor according to any one of claims 1 to 10,
wherein a weight-average molecular weight of the polymer A is in a range of 5,000 to 18,000.

12. A method of producing a planographic printing plate, comprising:
a step of image-exposing the planographic printing plate precursor according to any one of claims 1 to 11; and
a step of removing an unexposed area of the image recording layer with at least one of a printing ink or dampening water.

13. A method of producing a planographic printing plate comprising:
an exposure step of image-wise exposing the planographic printing plate precursor according to any one of claims 1 to 11 to form an exposed area and an unexposed area; and
a step of supplying a developer having a pH of 2 or higher and 11 or lower to remove the unexposed area.

## Patentansprüche

1. Flachdruckplattenvorläufer, umfassend:
einen Träger; und
eine auf dem Träger gebildete Bildaufzeichnungsschicht,
worin die Bildaufzeichnungsschicht ein Polymer A umfasst, das eine Aufbaueinheit A1 mit einer ethylenisch ungesättigten Gruppe umfasst,
worin das gewichtsgemittelte Molekulargewicht des Polymers A im Bereich von 2.500 bis 35.000 liegt,
der Anteil der Aufbaueinheit A1 an dem Polymer A 15 mol-% oder mehr beträgt; und
der Schwefelgehalt des Polymers A im Bereich von 0,5 Masse-% bis 10 Masse-% liegt, bezogen auf die Gesamtmasse des Polymers A,
worin der Schwefelgehalt sich aus einer Aufbaueinheit, die aus einer monofunktionellen Thiolverbindung oder eine bifunktionellen Thiolverbindung abgeleitet ist, oder aus einer Aufbaueinheit, die aus einer polyfunktionellen Thiolverbindung mit 3 bis 10 funktionellen Gruppen abgeleitet ist, ergibt.

2. Flachdruckplattenvorläufer gemäß Anspruch 1, worin das gewichtsgemittelte Molekulargewicht des Polymers A im Bereich von 2.500 bis 20.000 liegt und
der Anteil der Aufbaueinheit A1 an dem Polymer A 30 mol-% oder mehr beträgt.

3. Flachdruckplattenvorläufer gemäß irgendeinem der Ansprüche 1 bis 2,
worin das Polymer A ein Sternpolymer ist, das eine Aufbaueinheit umfasst, die aus einer polyfunktionellen Thiolverbindung mit 3 bis 10 funktionellen Gruppen abgeleitet ist.

4. Flachdruckplattenvorläufer gemäß irgendeinem der Ansprüche 1 bis 3,
worin die ethylenisch ungesättigte Gruppe in dem Polymer A eine (Meth)acryloxygruppe ist.

5. Flachdruckplattenvorläufer gemäß irgendeinem der Ansprüche 1 bis 4,
worin das Polymer A als eine Aufbaueinheit B1 mit einer hydrophilen Gruppe eine Aufbaueinheit umfasst, die eine Etherbindung enthält.

6. Flachdruckplattenvorläufer gemäß irgendeinem der Ansprüche 1 bis 5,
worin die Bildaufzeichnungsschicht ferner eine polymerisierbare Verbindung und einen elektronenakzeptierenden Polymerisationsinitiator umfasst.

7. Flachdruckplattenvorläufer gemäß irgendeinem der Ansprüche 1 bis 6,
worin die Bildaufzeichnungsschicht ferner einen Infrarotabsorber umfasst.

8. Flachdruckplattenvorläufer gemäß irgendeinem der Ansprüche 1 bis 7,
worin die Bildaufzeichnungsschicht ferner ein Säure-Farbentwicklungsmittel umfasst.

9. Flachdruckplattenvorläufer gemäß irgendeinem der Ansprüche 1 bis 8,
worin die Bildaufzeichnungsschicht ferner Polymerpartikel umfasst.

10. Flachdruckplattenvorläufer gemäß irgendeinem der Ansprüche 1 bis 9,
worin der Flachdruckplattenvorläufer ein Flachdruckplattenvorläufer für die Entwicklung auf der Presse ist.

11. Flachdruckplattenvorläufer gemäß irgendeinem der Ansprüche 1 bis 10,
worin das gewichtsgemittelte Molekulargewicht des Polymers A im Bereich von 5.000 bis 18.000 liegt.

12. Verfahren zur Herstellung einer Flachdruckplatte, umfassend:
einen Schritt zur bildweisen Belichtung des Flachdruckplattenvorläufers gemäß irgendeinem der Ansprüche 1 bis 11; und
einen Schritt zum Entfernen eines nicht-belichteten Bereichs der Bildaufzeichnungsschicht mit zumindest einem von Drucktinte oder Anfeuchtwasser.

13. Verfahren zur Herstellung einer Flachdruckplatte, umfassend:
einen Belichtungsschritt zur bildweisen Belichtung des Flachdruckplattenvorläufers gemäß irgendeinem der Ansprüche 1 bis 11, um einen belichteten Bereich und einen nicht-belichteten Bereich zu bilden; und
einen Schritt zum Zuführen eines Entwicklers mit einem pH-Wert von 2 oder höher und 11 oder niedriger, um den nicht-belichteten Bereich zu entfernen.

## Revendications

1. Plaque originale de plaque d'impression lithographique comprenant :
un support ; et
une couche d'enregistrement d'image formée sur le support,
dans lequel la couche d'enregistrement d'image contient un polymère A qui inclut un motif constitutif A1 présentant un groupe éthyléniquement insaturé,
dans lequel un poids moléculaire moyen en poids du polymère A est dans une plage de 2500 à 35 000,
une teneur en motif constitutif A1 dans le polymère A est de 15 % en mol ou plus ; et
la teneur en soufre du polymère A est dans une plage de 0,5 % en masse à 10 % en masse par rapport à une masse totale du polymère A, dans lequel la teneur en soufre est dérivée d'un motif constitutif dérivé d'un composé thiol monofonctionnel ou d'un composé thiol bifonctionnel, ou d'un motif constitutif dérivé d'un composé thiol polyfonctionnel présentant 3 à 10 groupes fonctionnels.

2. Plaque originale de plaque d'impression lithographique selon la revendication 1,
dans lequel le poids moléculaire moyen en poids du polymère A est dans une plage de 2500 à 20 000, et
la teneur en motif constitutif A1 dans le polymère A est de 30 % en mole ou plus.

3. Plaque originale de plaque d'impression lithographique selon l'une quelconque des revendications 1 à 2,
dans lequel le polymère A est un polymère en étoile incluant un motif constitutif dérivé d'un composé thiol polyfonctionnel présentant 3 à 10 groupes fonctionnels.

4. Plaque originale de plaque d'impression lithographique selon l'une quelconque des revendications 1 à 3,
dans lequel le groupe éthyléniquement insaturé dans le polymère A est un groupe (méth)acryloxy.

5. Plaque originale de plaque d'impression lithographique selon l'une quelconque des revendications 1 à 4,
dans lequel le polymère A inclut un motif constitutif incluant une liaison éther en tant que motif constitutif B1 présentant un groupe hydrophile.

6. Plaque originale de plaque d'impression lithographique selon l'une quelconque des revendications 1 à 5,
dans lequel la couche d'enregistrement d'image inclut en outre un composé polymérisable et un initiateur de polymérisation accepteur d'électrons.

7. Plaque originale de plaque d'impression lithographique selon l'une quelconque des revendications 1 à 6,
dans lequel la couche d'enregistrement d'image inclut en outre un absorbant d'infrarouges.

8. Plaque originale de plaque d'impression lithographique selon l'une quelconque des revendications 1 à 7,
dans lequel la couche d'enregistrement d'image inclut en outre un agent acide de développement de couleur.

9. Plaque originale de plaque d'impression lithographique selon l'une quelconque des revendications 1 à 8,
dans lequel la couche d'enregistrement d'image inclut en outre des particules polymères.

10. Plaque originale de plaque d'impression lithographique selon l'une quelconque des revendications 1 à 9,
dans lequel la plaque originale de plaque d'impression lithographique est une plaque originale de plaque d'impression lithographique pour un développement sur presse.

11. Plaque originale de plaque d'impression lithographique selon l'une quelconque des revendications 1 à 10,
dans lequel un poids moléculaire moyen en poids du polymère A est dans une plage de 5000 à 18 000.

12. Procédé de production d'une plaque d'impression lithographique, comprenant :
une étape d'exposition dans le sens image de la plaque originale de plaque d'impression lithographique selon l'une quelconque des revendications 1 à 11 ; et
une étape de retrait d'une zone non exposée de la couche d'enregistrement d'image avec au moins l'une d'une encre d'impression ou d'une eau de mouillage.

13. Procédé de production d'une plaque d'impression lithographique comprenant :
une étape d'exposition consistant à exposer dans le sens image la plaque originale de plaque d'impression lithographique selon l'une quelconque des revendications 1 à 11 pour former une zone exposée et une zone non exposée ; et
une étape de fourniture d'un révélateur présentant un pH de 2 ou plus et de 11 ou moins pour retirer la zone non exposée.
